# EUROPEAN PATENT SPECIFICATION

(11) **EP 2 988 583 B1**
(45) Date of publication and mention of the grant of the patent: **10.10.2018**
(21) Application number: 14883532.5
(22) Date of filing: 20.06.2014
(51) Int. Cl.: H05K 13/00, H05K 13/08, G05B 19/418

(54) **SUBSTRATE WORKING DEVICE, SUBSTRATE WORKING METHOD, AND SUBSTRATE WORKING SYSTEM**
SUBSTRATBEARBEITUNGSVORRICHTUNG, SUBSTRATBEARBEITUNGSVERFAHREN UND SUBSTRATBEARBEITUNGSSYSTEM
DISPOSITIF DE TRAITEMENT DE SUBSTRAT, PROCÉDÉ DE TRAITEMENT DE SUBSTRAT ET SYSTÈME DE TRAITEMENT DE SUBSTRAT

(43) Date of publication of application: 24.02.2016
(73) Proprietor: Yamaha Hatsudoki Kabushiki Kaisha, Iwata-shi, Shizuoka-ken 438-8501 (JP)
(72) Inventor: SARUWATARI, Yutaka, Iwata-shi Shizuoka-ken 438-8501 (JP)
(74) Representative: Müller-Boré & Partner Patentanwälte PartG mbB
(86) International application number: PCT/JP2014/066468
(87) International publication number: WO 2015/194045

(56) References cited:
- JP-A- 2004 134 691
- JP-A- 2004 303 819
- JP-A- 2010 232 218
- JP-A- 2013 105 896
- JP-A- 2013 105 897
- JP-A- 2013 197 448
- US-A1- 2006 200 264
- US-A1- 2012 249 772

## Description

### Technical Field

The present invention relates to a substrate working device, a substrate working method and a substrate working system, and more particularly, it relates to a substrate working device, a substrate working method and a substrate working system each performing prescribed work processing such as solder printing, solder application, substrate appearance inspection before loading of electronic components, loading of electronic components, substrate appearance inspection after loading of electronic components, reflow processing of substrates loaded with electronic components and the like.

### Background Technique

A substrate working device performing prescribed work processing on substrates loaded with electronic components is known in general. Such a substrate working device is disclosed in Japanese Patent Laying-Open No. 2013-238909, for example.

During automatic running by such a substrate working device, various types of operations by an operator are required. The operations by the operator include removal of an error factor and a restart operation in a case where the substrate working device error-stops, a setup operation for starting next automatic running after termination of operations for an estimated substrate number, for example. In a case where the aforementioned operation is required in response to the status of the automatic running, the substrate working device temporarily stops the automatic running, and performs an operator operation request requesting the operator to perform the operation.

In the aforementioned Japanese Patent Laying-Open No. 2013-238909, there are disclosed operations of calculating a working time making the operator execute the setup operation (i.e., a time for performing a request for execution of the setup operation) and performing posting to the operator when reaching a time (preparation starting time) advanced from the working time by a preparation time required for the operation in a circuit board production line constituted of a plurality of substrate working devices.

### Prior Art

### Patent Document

Patent Document 1: Japanese Patent Laying-Open No. 2013-238909

US 2012/249772 A1 discloses a component mounting device including a detection unit which is able to detect a first detection target which is provided on a substrate and a second detection target which is provided to be separated by a predetermined distance from the first detection target on the substrate.

US 2006/200264 A1 discloses an assisting-work management apparatus and an assisting-work management program. A responsible-worker determining portion determines a responsible worker, and an assigned-work informing portion informs the responsible worker of the objective work assigned to the worker.

### Summary of the Invention

### Problem to be Solved by the Invention

On the actual job site, however, the operator may not infrequently be required to leave from the production line, and hence the operator is not necessarily capable of working in response to a setup operation time (execution time for the operation request). Further, an error of the substrate working device contingently occurs regardless of a schedule such as the setup operation time, to stop the substrate working device. In a case where the operator operation request is generated due to an error stop or transition to the setup operation in the absence of the operator, therefore, the production line must be stopped until the operator returns to the production line, and working efficiency remarkably reduces. In general, therefore, there is such a problem that the working efficiency reduces due to stoppage of the device in a case where the operator operation request is generated under such a situation that no operation by the operator can be performed particularly in the absence of the operator or the like.

The present invention has been proposed in order to solve the aforementioned problem, and one object of the present invention is to provide a substrate working device, a substrate working method and a substrate working system each capable of inhibiting working efficiency from reduction resulting from stoppage of the device under such a situation that no operation by an operator can be performed.

### Means for Solving the Problem

A substrate working device according to a first aspect of the present invention is defined in claim 1.

In the present invention, the "operator operation request" is a concept showing that the control portion requests the operator to execute an operation in a case where the operation by the operator is required during the automatic running of the substrate working device. The operator operation request includes an error response request requesting the operator to perform an operation for responding to an error with respect to the error occurring in the substrate working device, for example. Further, the operator operation request includes a request to the operator for execution of a setup operation in a case of making transition to the setup operation for starting next automatic running after termination of work processing for a previously set estimated substrate number, for example.

In the substrate working device according to the first aspect of the present invention, as hereinabove described, the control portion acquiring the compatibility/incompatibility status of the operator as to whether or not the operator is compatible with the operator operation request is provided, and the control portion is configured to perform control of switching the running mode for the automatic running to the normal mode and to the continuation preference mode of the running condition that the operator operation request is harder to generate than in the normal mode (such a running condition that the control portion hardly generates the operator operation request or less performs the operator operation request). Thus, generation of the operator operation request accompanying stoppage of the device such as an error stop or a setup operation can be suppressed when switching the running mode to the continuation preference mode in a case where the compatibility/incompatibility status is incompatibility in the absence of the operator or the like. Consequently, it becomes possible to continue work processing on the substrate by the working portion without stopping the same also under such a situation that the compatibility/incompatibility status becomes incompatibility and no operation by the operator can be performed, whereby working efficiency can be inhibited from reduction resulting from stoppage of the device.

Preferably in the aforementioned substrate working device according to the first aspect, the operator operation request includes an error response request requesting the operator to perform an operation for responding to an error occurring during the automatic running, and the substrate working device is so configured that the running is performed under such a running condition that the error response request is harder to generate in the continuation preference mode than in the normal mode as to at least either one of an error stop condition for the automatic running and a working speed condition for the automatic running. When structuring the substrate working device in this manner, automatic running can be performed under the running condition that the error response request is hard to generate (such a running condition that the control portion hardly generates the error response request or less performs the error response request) in the continuation preference mode as to at least either one of the error stop condition and the working speed condition, whereby the possibility (frequency) of occurrence of an error stop can be effectively reduced. In the present invention, the "error stop condition" is a concept showing a condition for stopping the automatic running (a condition for determining whether or not to stop the automatic running) resulting from an error occurring in the substrate working device.

Preferably in this case, the control portion is configured to perform an error determination for performing the error response request on the basis of the error stop condition, and the substrate working device is so configured that whether or not to perform stoppage according to the error response request is determined on the basis of an error determination threshold at which the error determination is harder to perform in the continuation preference mode than in the normal mode as the error stop condition. When structuring the substrate working device in this manner, such a situation that the error determination threshold is reached and an error determination is performed during the automatic running can be suppressed in the continuation preference mode. Thus, reduction of working efficiency resulting from stoppage of the device can be suppressed. In the present invention, the "error determination" is a concept showing that the control portion determines to perform an error response request as a result of determining whether or not to perform the error response request to the operator.

Preferably in the aforementioned structure in which the continuation preference mode has the error determination threshold at which the error determination is harder to perform than in the normal mode, the control portion is configured to control the working portion to execute a retry operation for a failing operation in a case where an operation of the working portion included in the work processing fails, and the error determination threshold includes at least any one of an upper limit frequency up to an error determination on the retry operation by the working portion, a standby time up to an error determination on data transfer and a standby time up to an error determination on substrate transportation. When structuring the substrate working device in this manner, it is allowed to perform a larger number of times of the retry operation or a standby over a longer time in the continuation preference mode, also in a case where the error determination threshold is reached and the substrate working device is error-stopped in the normal mode. Consequently, a temporary error factor is naturally canceled due to repetition of the retry operation or the standby over a longer time, and a possibility that the operation can be continued without error-stopping the substrate working device increases. Thus, generation of an error response request (stoppage of the device) under a situation of incompatibility of the operator can be suppressed by allowing a possibility that a tact time (a working step time of the substrate working device per substrate) increases than in the normal mode.

Preferably in the aforementioned structure in which the continuation preference mode has the running condition that the error response request is harder to generate as to at least either one of the error stop condition and the working speed condition, the substrate working device is so configured that the running is performed in the continuation preference mode at a working speed setting set to a lower speed than in the normal mode as the working speed condition. When structuring the substrate working device in this manner, error occurrence frequency can be reduced by automatically running the substrate working device in the continuation preference mode at a lower speed than in the normal mode, whereby generation of the error response request (stoppage of the device) under a situation of operator incompatibility can be more suppressed.

Preferably in this case, the working speed setting includes at least either one of a working speed of the working portion and a simultaneous transportation number for the substrate by the transportation portion. When structuring the substrate working device in this manner, occurrence of an error resulting from the working speed of the working portion following various types of operations or an error resulting from the simultaneous transportation number for the substrate can be effectively reduced. In particular, individual variation (tolerance) becomes an unremovable error factor for an electronic component handled by the working portion or a substrate transported by the transportation portion, while occurrence of an error can be reduced by reliably performing operations or transportation at a lower speed, whereby it becomes possible to suppress generation of an error response request resulting from individual variation or the like.

Preferably in the aforementioned substrate working device according to the first aspect, the control portion is configured to acquire such future estimated incompatibility that the compatibility/incompatibility status becomes incompatibility and to switch the running mode to the continuation preference mode by determining that the compatibility/incompatibility status is incompatibility in a case where the current time reaches a beginning period of the estimated incompatibility. When structuring the substrate working device in this manner, the running mode can be reliably switched to the continuation preference mode in response to the estimated incompatibility of the operator in a case where a schedule when the operator becomes incompatible is previously determined.

Preferably in this case, the control portion is configured to acquire an ending period of the estimated incompatibility and to change the running condition in the continuation preference mode in response to a remaining time up to the ending period of the estimated incompatibility in the continuation preference mode. Even if the error response request or the setup operation is generated at timing when the ending period of the estimated incompatibility approaches, the operator can immediately respond and hence influence exerted on the working efficiency becomes remarkably small. When changing the running condition in the continuation preference mode in consideration of influence (risk) exerted on production efficiency in a case where stoppage of the device occurs in response to the remaining time up to the ending period of the estimated incompatibility, therefore, it becomes possible to further suppress reduction of the working efficiency.

Preferably in the aforementioned structure in which the control portion changes the running condition in the continuation preference mode in response to the remaining time up to the ending period of the estimated incompatibility, a plurality of continuation preference modes are so provided that running conditions stepwisely differ from each other, and the control portion is configured to select the continuation preference mode of such a running condition that the operator operation request is harder to generate from among the plurality of continuation preference modes as the remaining time up to the ending period of the estimated incompatibility increases in the continuation preference mode. When structuring the substrate working device in this manner, occurrence of stoppage of the device can be further suppressed in a case where a stop time in a case where stoppage of the device occurs (a case where the remaining time is large). In a case where the stop time is short (a case where the remaining time is small), the continuation preference mode giving further priority to efficiency can be selected. Consequently, it becomes possible to further effectively suppressing reduction of the working efficiency while suppressing stoppage of the device under a situation of incompatibility of the operator.

Preferably in the aforementioned structure in which the control portion changes the running condition in the continuation preference mode in response to the remaining time up to the ending period of the estimated incompatibility, the operator operation request includes a request for execution of a setup operation for the automatic running, and the control portion is configured to change a transportation time interval for the substrate by the transportation portion in response to the remaining time up to the ending period of the estimated incompatibility in the continuation preference mode. When structuring the substrate working device in this manner, the tact time of the device can be controlled by the change of the transportation time interval, whereby start timing for the setup operation can be controlled. Thus, request timing for the setup operation can be delayed under such a situation that the operator is incompatible, whereby simplification of the setup operation can be attained by preventing solidification and deterioration of paste solder or a dispensing solution (an adhesive or the like) employed for manufacturing of electronic circuit boards, for example. Consequently, the working efficiency including the setup operation can be improved.

Preferably in this case, the control portion is configured to lengthen the transportation time interval as the number of remaining substrates up to transition to the setup operation is small with respect to the remaining time and to control the transportation portion to execute substrate transportation in a case where an elapsed time from a previous transportation time is larger than the transportation time interval in the continuation preference mode. When structuring the substrate working device in this manner, request timing for the setup operation can be more reliably matched with timing (the ending period of the estimated incompatibility) when the compatibility/incompatibility status of the operator becomes incompatibility in a case where the number of the remaining substrates disappears for making transition to the setup operation during the continuation preference mode. Consequently, the working efficiency can be further improved by reducing the standby time up to starting of the setup operation.

Preferably, the aforementioned substrate working device according to the first aspect further includes a communication portion provided on an upstream side or a downstream side of the transportation portion and network-connected with another substrate working device constituting a production line for an electronic circuit board, and the control portion is configured to post the acquired compatibility/incompatibility status to the other substrate working device through the communication portion. When structuring the substrate working device in this manner, switching to the continuation preference mode responsive to the compatibility/incompatibility status of the operator can be collectively performed with respect to a plurality of substrate working devices constituting the production line, for example. At this time, the operator can reflect the compatibility/incompatibility status also with respect to the other substrate working device when performing an input of the compatibility/incompatibility status or the like with respect to a prescribed substrate working device, whereby input forgetting of the compatibility/incompatibility status or the like can be suppressed.

A substrate working method according to a second aspect of the present invention is defined in claim 12.

In the substrate working method according to the second aspect of the present invention, as hereinabove described, the step of acquiring the compatibility/incompatibility status of the operator as to whether or not the operator is compatible with respect to the operator operation request requesting the operator to perform the prescribed operation in response to the status of the automatic running and the step of switching the running mode of the substrate working device to the normal mode and to the continuation preference mode of the running condition that the operator operation request is harder to generate than in the normal mode in response to the compatibility/incompatibility status are provided. Thus, it becomes possible to continue work processing without stopping the same to the utmost when switching the running mode to the continuation preference mode in a case where the compatibility/incompatibility status is incompatibility in the absence of the operator or the like, whereby reduction of the working efficiency resulting from stoppage of the device can be suppressed.

Preferably, the aforementioned substrate working method according to the second aspect further includes a step of performing running under a running condition rendering the operator operation request hard to generate by increase of a unit operation time required from introduction of the substrate up to introduction of a next substrate or by allowing the increase of the unit operation time in the continuation preference mode as compared with a running condition in the normal mode. When structuring the substrate working method in this manner, automatic running of the substrate working device can be performed under such a running condition that the operator operation request for an error stop or the like is hard to generate in the continuation preference mode, in place of increasing a unit working time (tact time) beyond that in the normal mode. Consequently, such a situation that the operation stops due to an error stop or the like in the absence of the operator can be suppressed although there is a possibility that the tact time temporarily increases beyond that in the normal mode, whereby reduction of the working efficiency resulting from stoppage of the device can be suppressed.

Preferably in the aforementioned substrate working method according to the second aspect, the operator operation request includes an error response request requesting the operator to perform an operation for responding to an error occurring during the automatic running of the substrate working device, and the method further includes a step of performing running under such a running condition that the error response request is harder to generate in the continuation preference mode than in the normal mode as to at least either one of an error stop condition for the substrate working device and a working speed condition for the substrate working device. When structuring the substrate working method in this manner, automatic running can be performed in the continuation preference mode under such a running condition that the error response request is hard to generate as to at least either one of the error stop condition and the working speed condition, whereby a possibility (frequency) that the error stop occurs can be effectively reduced.

A substrate working system according to a third aspect of the present invention is defined in claim 15.

In the substrate working system according to the third aspect of the present invention, as hereinabove described, the server device is configured to acquire the compatibility/incompatibility status of the operator as to whether or not the operator is compatible with the operator operation request and to post the acquired compatibility/incompatibility status to the substrate working device, and the substrate working system is so configured that the running mode for automatic running of the substrate working device is switched to the normal mode and to the continuation preference mode of the running condition that the operator operation request is harder to generate than in the normal mode in response to the compatibility/incompatibility status. Thus, it becomes possible to continue work processing without stopping the same to the utmost when switching the running mode to the continuation preference mode in a case where the compatibility/incompatibility status is incompatibility in the absence of the operator or the like, whereby reduction of the working efficiency resulting from stoppage of the device can be suppressed.

### Effect of the Invention

According to the present invention, as hereinabove described, reduction of working efficiency resulting from stoppage of a device can be suppressed under such a situation that no operation by an operator can be performed.

### Brief Description of the Drawings

[Fig. 1] A diagram showing the overall structure of a component mounting system according to each of first to fifth embodiments of the present invention.
[Fig. 2] A schematic plan view of a component mounting device according to the first embodiment of the present invention.
[Fig. 3] A diagram showing a compatibility/incompatibility status table.
[Fig. 4] A diagram showing a compatibility/incompatibility status set screen.
[Fig. 5] A diagram showing an estimated incompatibility status table.
[Fig. 6] A diagram showing an error stop condition table.
[Fig. 7] A flowchart for illustrating monitoring processing for estimated incompatibility according to the first embodiment of the present invention.
[Fig. 8] A flowchart for illustrating running condition change processing according to the first embodiment of the present invention.
[Fig. 9] A diagram showing a working speed condition table.
[Fig. 10] A flow chart for illustrating running condition change processing according to the second embodiment of the present invention.
[Fig. 11] A diagram showing an error stop condition table according to the third embodiment of the present invention.
[Fig. 12] A diagram showing a working speed condition table according to the third embodiment of the present invention.
[Fig. 13] A diagram showing a remaining time condition table.
[Fig. 14] A flowchart showing retry upper limit frequency acquisition processing according to the third embodiment of the present invention.
[Fig. 15] A flowchart showing speed setting acquisition processing according to the third embodiment of the present invention.
[Fig. 16] A schematic side sectional view for illustrating the structure of a printer according to the fourth embodiment of the present invention.
[Fig. 17] A diagram showing an estimated production number table.
[Fig. 18] A flowchart showing transportation time interval change processing according to the fourth embodiment of the present invention.
[Fig. 19] A flowchart showing transportation time interval acquisition processing according to the fourth embodiment of the present invention.
[Fig. 20] A diagram for illustrating functions of the fourth embodiment of the present invention.
[Fig. 21] A flowchart for illustrating monitoring processing for estimated incompatibility according to the fifth embodiment of the present invention.

### Modes for Carrying Out the Invention

Embodiments of the present invention are now described on the basis of the drawings.

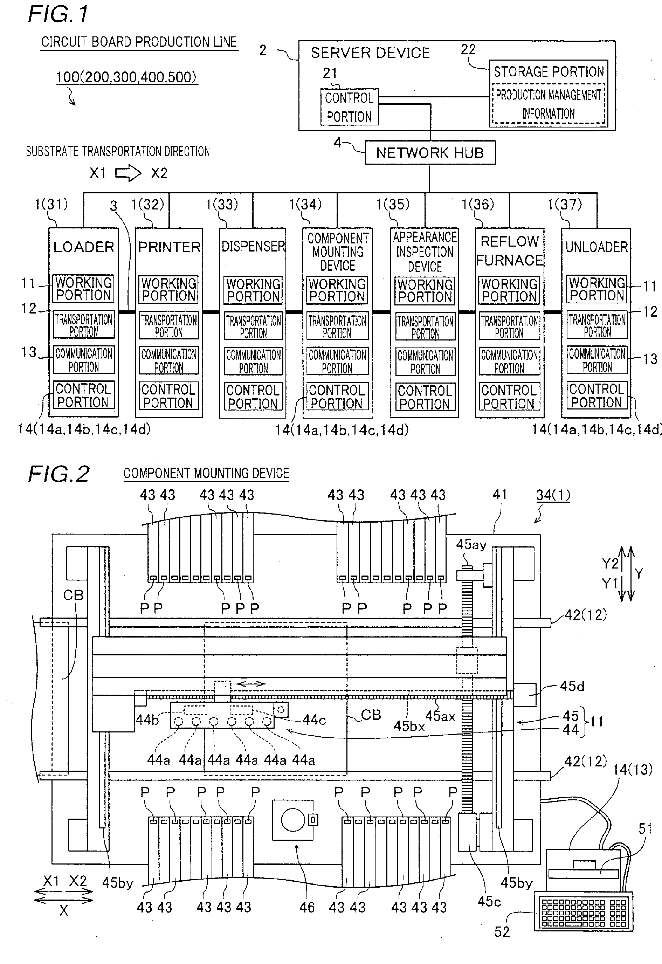

First, a component mounting system 100 according to a first embodiment of the present invention is described with reference to Figs. 1 to 8. The component mounting system 100 is an example of the "substrate working system" in the present invention.

The component mounting system 100 according to the first embodiment of the present invention constitutes a production line for electronic circuit boards whose substrates are loaded with electronic components, as shown in Fig. 1. The component mounting system 100 includes a plurality of substrate working devices 1 and a server device 2. The respective substrate working devices 1 are connected with each other through a transportation line 3, and the component mounting system 100 is configured to be capable of transporting substrates from the device(s) on an upstream side toward the device(s) on a downstream side.

The server device 2 and the respective substrate working devices 1 are connected with each other to be mutually communicable through a network. The respective ones of the substrate working devices 1 are also mutually communicable. The server device 2 mainly includes a control portion 21 and a storage portion 22. The server device 2 has a function as a management computer executing control programs and unifying the whole of the component mounting system 100. Management information such as a production program related to production of electronic circuit boards is stored in the storage portion 2.

Each substrate working device 1 includes a working portion 11, a transportation portion 12, a communication portion 13 and a control portion 14.

The working portion 11 has a function of performing prescribed work processing on substrates CB by automatic running, and the structure (construction) varies with the substrate working device 1 in response to work contents. The transportation portion 12 has a function of performing introduction/discharge of the substrates CB (see Fig. 2) loaded with electronic components (see Fig. 2, hereinafter referred to as components P), and constructs part of the transportation line 3. The communication portion 13 has a function of performing communication with the server unit 2 and the remaining substrate working devices 1 through the network. The respective substrate working devices 1 are self-supporting devices, the respective ones of which are operation-controlled by the control portions 14. In other words, operations of the respective devices are not dependent on the server device 2, but individually controlled by the respective control portions 14.

Fig. 1 shows a specific example of the production line for the electronic circuit boards loaded with the electronic components. In the component mounting system 100 shown in Fig. 1, a loader (substrate supply device) 31, a printer 32, a dispenser 33, a component mounting device 34, an appearance inspection device 35, a reflow furnace 36 and an unloader (substrate recovery device) 37 are arranged in this order from the upstream side (X1 side) toward the downstream side (X2 side) of the transportation line 3. The respective substrate working devices 1 (31 to 37) and the server device 2 are connected with each other by a network hub 4.

A specific structure of each substrate working device 1 shown in Fig. 1 is now described.

A generally known structure can be employed for the device structure (construction) of each substrate working device 1 itself, and the control portion 14 (programs run by the control portion 14) of each is different from that of the prior art. In the first embodiment, detailed description is made as to the component mounting device 34, and only profiles are described as to the remaining loader 31, the printer 32, the dispenser 33, the appearance inspection device 35, the reflow furnace 36 and the unloader 37.

The loader 31 has functions of holding a large number of substrates (wiring boards) CB before being mounted with the components P and discharging the substrates CB to the transportation line 3. The working portion 11 of the loader 31 performs a substrate supply operation of delivering the substrates CB to the transportation line 3 through the transportation portion 12. The components P are bitlike electronic components such as LSIs, ICs, transistors, capacitors and resistors.

The printer 32 is a screen printer. The working portion 11 of the printer 32 performs a solder printing operation of applying paste solder to the substrates CB. The dispenser 33 is a device applying a dispensing solution such as an adhesive for component fixation to the substrates CB. The working portion 11 of the dispenser 33 performs a solution applying operation of applying the dispensing solution onto surfaces of the substrates CB.

The component mounting device 34 is a device mounting (loading) the plurality of components (electronic components) P on the substrates CB subjected to the solder printing and the solution application. The working portion 11 of the component mounting device 34 performs a mounting operation of mounting (loading) the components P on the substrates CB.

The working portion 11 and the transportation portion 12 of the component mounting device 34 are set on a base 41, as shown in Fig. 2. The working portion 11 is arranged above the transportation portion 12 (on the upper side of the plane). The transportation portion 12 is configured to hold the substrates CB on a pair of conveyors 42 and to perform introduction, holding and discharge of the substrates CB. A large number (a plurality) of table feeders 43 are arrayed on both sides (on a Y1 side and a Y2 side) of the transportation portion 12. Each tape feeder 43 delivers a tape holding a plurality of components P, and performs component supply from a forward end portion.

The working portion 11 includes a head unit 44 including a plurality of mounting heads 44a and a moving mechanism 45 horizontally moving the head unit 44. The moving mechanism 45 is constituted of direct-acting mechanisms 45ax and 45ay such as ball screw mechanisms consisting of ball screw shafts and ball nuts respectively and guide mechanisms (guide rail) 45bx and 45by as to an X-axis and a Y-axis in the horizontal direction. The moving mechanism 45 drives a Y-axis motor 45c and an X-axis motor 45d and rotates/drives the ball screw shafts, thereby moving the head unit 44 in a Y direction and an X direction above the transportation portion 12.

The head unit 44 is provided with a Z-axis moving mechanism having a Z-axis motor 44b for moving up/down the plurality of mounting heads 44a and an R-axis moving mechanism having an R-axis motor 44c rotating the mounting heads 44a on central axes. The mounting heads 44a are capable of adsorbing and releasing the components P with a negative pressure supplied from an unshown negative pressure supply mechanism. The mounting heads 44a perform component adsorption and component mounting to mounting positions for the substrates CB with movement of the respective axes X, Y, Z and R.

A component recognition camera 46 directing an imaging direction upward is set on the base 41. The component recognition camera 46 picks up lower surface images of adsorbed components when the mounting heads 44a adsorbing the components pass through a position above the component recognition camera 46. As to the picked-up images, determination as to whether or not the components have been adsorbed by the mounting heads 44a and correction of adsorption misregistration in component loading on the mounting positions are performed.

As shown in Fig. 1, the appearance inspection device 35 is an optical inspection device picking up images of the mounted substrates CB and inspecting mounted states of the respective components P by image recognition. The working portion 11 performs an imaging operation of picking up images of the substrates CB mounted with the components. The control portion 14 performs determination as to the presence or absence of defective mounting or the like on the basis of the picked-up images as obtained.

The reflow furnace 36 is a device melting solder by performing heat treatment and bonding electrodes of the components P to electrode portions on the substrates CB. The working portion 11 of the reflow furnace 36 performs the heat treatment of the substrates CB. The unloader 37 is a device recovering the substrates CB after being mounted with the components P from the transportation line 3. The working portion 11 of the unloader 37 performs a recovery operation of the substrates CB from the transportation line 3 through the transportation portion 12. Thus, the component mounting system 100 in the first embodiment is constituted.

The structure of the control portion 14 of each substrate working device 1 according to the first embodiment is now described. In the first embodiment, the description is made with reference to the control portion 14 of the component mounting device 34.

As shown in Fig. 2, the control portion 14 is a computer constituted of a CPU, a memory and the like on a hardware structure. The CPU functions as the control portion 14 of the component mounting device 34 by running control programs stored in the memory. Further, the control portion 14 includes a display portion 51 and an input portion 52. The display portion 51 is a liquid crystal monitor or the like, for example, and has a function of performing various types of screen displays related to the component mounting device 34 under control of the control portion 14. The input portion 52 is configured to accept input operations from an operator with respect to the component mounting device 34 (the control portion 14). The input portion 52 consists of a keyboard and a mouse, a touch screen and the like, for example.

According to the first embodiment, the control portion 14 is configured to perform an operator operation request requesting the operator to perform a prescribed maintenance operation during running, and has a function of acquiring a compatibility/incompatibility status of the operator as to whether or not he/she is compatible with this operator operation request. The control portion 14 is configured to perform control of switching a running mode for the automatic running to a normal mode and to a continuation preference mode of such a running condition that the operator operation request is harder to generate (such a running condition that the control portion 14 hardly generates the operator operation request or less performs the operator operation request) than in the normal mode in response to the compatibility/incompatibility status.

The operator operation request is processing (processing of the control portion 14) requesting the operator to perform the prescribed maintenance operation, and particularly processing accompanied with temporary stoppage of the automatic running of the substrate working device 1. The operator operation request includes an error response request requesting the operator to perform a maintenance operation for responding to an error occurring in the substrate working device 1, a request for execution of a setup operation and the like, for example. In the component mounting device 34, the error response request is processing of requesting the operator to perform the maintenance operation for the purpose of running continuation in such a running situation that a component recognition error, a component adsorption error, a data transfer error (file reading error), a substrate transportation error or the like occurs, for example. The component recognition error is an error in a case where a result of component recognition by the component recognition camera 46 is not normal. The component adsorption error is an error in a case where component adsorption with the mounting heads 44a cannot be normally performed. In a case where an operation (a component recognition operation or a component adsorption operation) of the working portion 11 included in work processing fails, the control portion 14 controls the working portion 11 to execute a retry operation for the failing operation (processing of controlling the working portion 11 to execute the same operation again). A retry upper limit of a prescribed number of times is set for the component recognition and the component adsorption, and the control portion 14 repetitively executes (retries) the component recognition operation or the component adsorption operation even if failing in the operation, until reaching the retry upper limit. In a case of failing also when reaching the retry upper limit, the control portion 14 performs an error determination and stops the automatic running.

The data transfer error (file reading error) is an error in a case where transfer of data (reading of files) related to the substrates CB cannot be normally performed when introducing the substrates CB from the device on the upstream side of the production line. The substrate transportation error is an error in a case where the substrates CB cannot be normally transported to a prescribed operation position when introducing the substrates CB from the device on the upstream side or the like. A prescribed standby time is set for the file reading and the substrate transportation, and the control portion 14 continuously executes file reading and substrate transportation processing until reaching the standby time. In a case where the processing is not completed even if reaching the standby time, the control portion 14 performs an error determination and stops the automatic running.

In a case of performing the error response request when the aforementioned error such as the component adsorption error occurs, the control portion 14 posts the error to the operator by buzzing or lamp lighting (each not shown). When the operator performs a restoration operation eliminating the error factor in response to the error response request and restarts the substrate working device 1, the automatic running is restarted.

The setup operation is a preparatory operation performed while stopping the running for next automatic running in a case where an operation on substrates CB by an estimated production number in the automatic running terminates. In the setup operation, exchange and replenishment of components loaded on the substrates, various operations for responding to change of substrate types and the like, for example, are performed by the operator. The control portion 14 performs a request for execution of the setup operation to the operator in a case where the operation by the estimated production number terminates (i.e., in a case of making transition to the setup operation). When the operator completes the setup operation and restarts the substrate working device 1, next automatic running by the estimated production number is started.

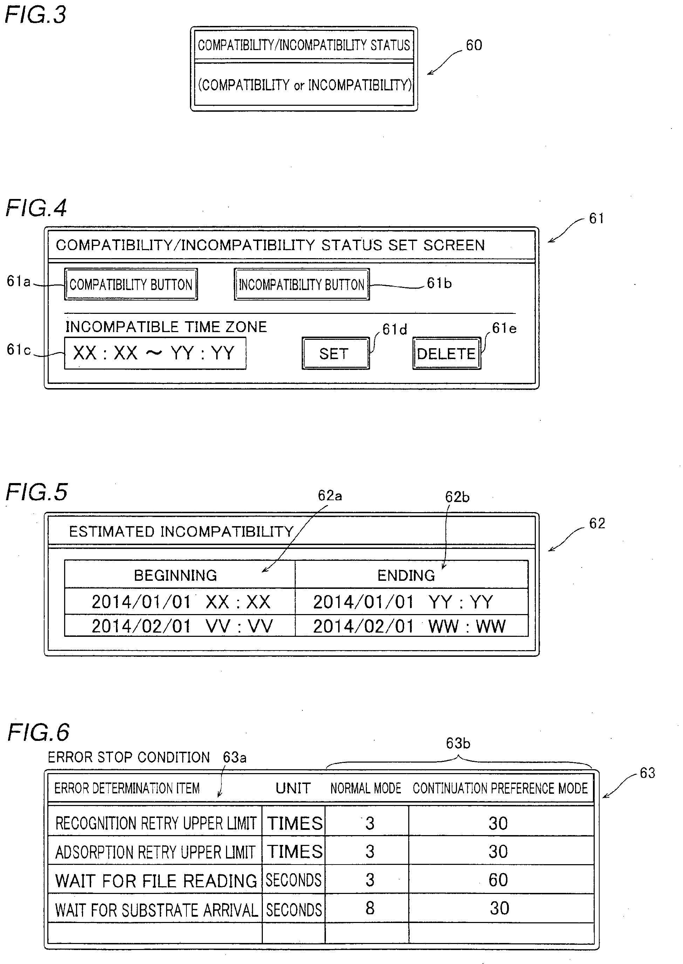

The compatibility/incompatibility status is information indicating the current status of the operator as to whether or not the operator is compatible with the aforementioned operator operation request (the error response request or the request for execution of the setup operation) by execution of the maintenance operation or the setup operation. The compatibility/incompatibility status indicates either status of "compatibility" or "incompatibility". The control portion 14 has a compatibility/incompatibility status table 60 in the memory as shown in Fig. 3, and is configured to store either information (flag) of "compatibility" or "incompatibility". The "compatibility" and "incompatibility" correspond to operator's presence and absence on the production line in principle. This is because he/she cannot respond to the aforementioned operator operation request in a case where the operator is absent. According to the first embodiment, the control portion 14 performs control of switching the running mode to the normal mode in a case where the compatibility/incompatibility status is compatibility and switching the same to the continuation preference mode in a case where the compatibility/incompatibility status is incompatibility.

In the normal mode, a running condition minimizing a tact time (maximizing working efficiency of the device) is set on the premise of the "compatibility" status. In a case where production efficiency can be raised when the operator responds every time even if the error response request is generated with a certain measure of frequency, for example, a running condition giving priority to the production efficiency is set in the normal mode.

When the operator operation request is generated under the "incompatibility" status, on the other hand, the automatic running must be continuously stopped until the substrate working device 1 enters the "compatibility" status. In the continuation preference mode, therefore, such a running condition that the aforementioned operator operation request (the error response request or the request for execution of the setup operation) is harder to generate than in the normal mode is set.

For the continuation preference mode according to the first embodiment, such a running condition that the error response request is harder to generate than in the normal mode is set as to an error stop condition for the automatic running. In other words, a running condition rendering the operator operation request hard to generate is set in the continuation preference mode by allowing increase of the tact time (increasing a retry frequency or a standby time) as compared with the running condition in the normal mode.

Details of control by the control portion 14 are now described.

As shown in Figs. 4 and 5, the control portion 14 is configured to display a compatibility/incompatibility set screen 61 and an estimated incompatibility table 62 on the display portion 51. Further, the control portion 14 stores an error stop condition table 63 in the memory as running conditions for the automatic running of the substrate working device 1, as shown in Fig. 6.

A compatibility button 61a, an incompatibility button 61b, a time zone input window 61c for estimated incompatibility, a set button 61d and a delete button 61d are displayed on the compatibility/incompatibility set screen 61. The operator so inputs the compatibility button 61a and the incompatibility button 61b that the compatibility/incompatibility status as to whether the substrate working device 1 is currently in the "compatibility" status or the "incompatibility" status is acquired by the control portion 14.

The estimated incompatibility indicates such future estimation that the compatibility/incompatibility status becomes incompatibility, and includes the beginning period and the ending period of the estimated incompatibility. In other words, the control portion 14 is configured to accept an input of a time zone (incompatibility time zone) including the beginning period and the ending period of the estimated incompatibility. The operator so inputs the beginning period and the ending period in the time zone input window 61c and inputs the set button 61c that the estimated incompatibility is accepted by the control portion 14. The accepted estimated incompatibility is registered in the estimated incompatibility table 62 of Fig. 5.

The estimated incompatibility table 62 is capable of registering a plurality of estimated incompatibilities including beginning periods (starting times) 62a and ending periods (ending times) 62b. When the operator selects any estimated incompatibility as registered and inputs another time zone through the time zone input window 61c and the set button 61d, correction (change) of the time zone is possible. When the operator selects any estimated incompatibility and inputs the delete button 61d on the compatibility/incompatibility set screen 61, deletion of the estimated incompatibility is possible.

Conditions for the control portion 14 for performing the error response request are set in the error stop condition table 63 as to the respective ones of the normal mode and the continuation preference mode. The error stop condition table 63 includes error determination items 63a and error determination thresholds 63b for the respective items. The error determination items are lists of events serving as objects of error response requests. The error determination thresholds 63b are thresholds (conditions) for performing error response requests as to the respective error determination items 63a. During the automatic running, the control portion 14 performs an error determination for performing an error response request on the basis of the error stop conditions. In other words, the control portion 14 determines whether or not the error determination item has reached the error determination threshold every error determination item, and performs the error determination as to the item having reached the error determination threshold. The control portion 14 performs an error response request as to the item on which the same has performed the error determination.

The error determination thresholds 63b include an upper limit frequency (threshold) up to an error determination on a retry operation by the working portion 11, a standby time (threshold) up to an error determination on data transfer (file reading for the substrates CB) and a standby time (threshold) up to an error determination on substrate transportation respectively. In the case of the component mounting device 34, a recognition retry for the components P and an adsorption retry for the components P are included as examples in retry operations by the working portion 11. As an example of the error determination on the substrate transportation, an error determination on an arrival waiting time for the substrates CB at a prescribed mounting operation position is included.

In the example of Fig. 6, a recognition retry upper limit and an adsorption retry upper limit are set as three times respectively, a file reading waiting time is set as three seconds and a substrate arrival waiting time is set as eight seconds as to the normal mode. In the continuation preference mode, on the other hand, the recognition retry upper limit and the adsorption retry upper limit are set to 30 times respectively, the file reading waiting time is set to 60 seconds and the substrate arrival waiting time is set to 30 seconds, for example, and the determination thresholds are more relaxed than in the normal mode.

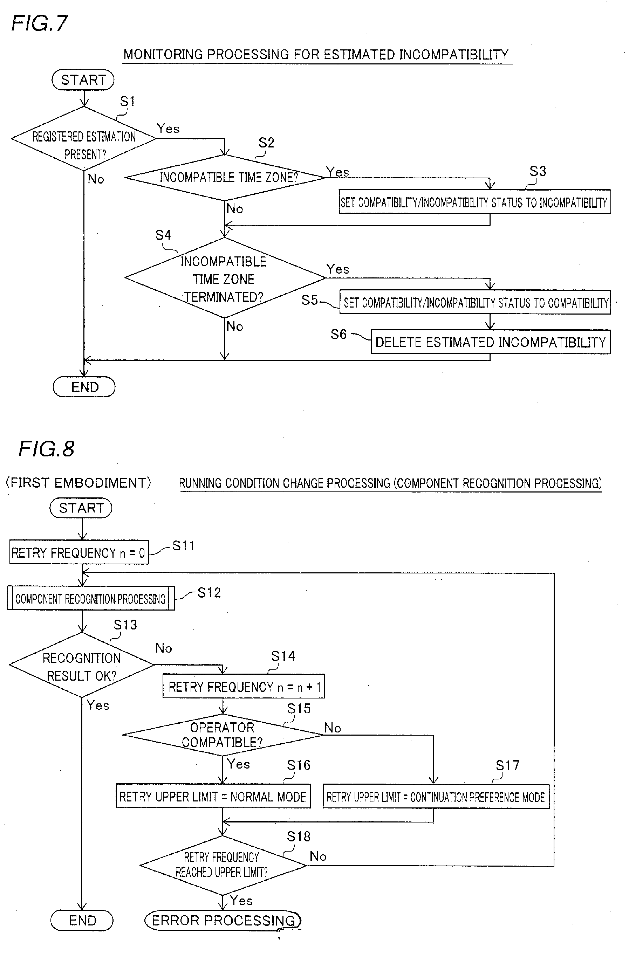

Control processing by the control portion 14 is now described. First, monitoring processing for estimated incompatibility by the control portion 14 is described with reference to Fig. 7.

At a step S1 of Fig. 7, the control portion 14 determines whether or not estimated incompatibility already registered in the estimated incompatibility table 62 is present. In a case where no estimated incompatibility is present, the control portion 14 terminates the monitoring processing. In a case where the estimated incompatibility is present, the control portion 14 determines whether or not the current time belongs to the incompatibility time zone set to the estimated incompatibility at a step S2. In a case where the current time is a time between the starting time and the ending time, the control portion 14 updates the compatibility/incompatibility status to "incompatibility" at a step S3. In a case where the current time is before the starting time or after the ending time, or in a case where the control portion 14 has updated the compatibility/incompatibility status to "incompatibility" at the step S3, the processing advances to a step S4.

At the step S4, the control portion 14 determines whether or not the incompatibility time zone has terminated. In a case where the current time is before the ending time, the control portion 14 terminates the processing as such. In a case where the current time is after the ending time, on the other hand, the control portion 14 updates the compatibility/incompatibility status to "incompatibility" at a step S5, and deletes the estimated incompatibility passing the ending period (ending time) at a step S6. The control portion 14 updates the compatibility/incompatibility status along registered estimated incompatibility by continuously performing the above monitoring processing.

Running condition change processing of changing an error stop condition (running condition) by switching between the normal mode and the continuation preference mode by the control portion 14 is now described with reference to Fig. 8. The following description is made with reference to processing of changing the retry upper limit frequency (determination threshold) of component recognition processing from among the error determination items shown in Fig. 6.

When executing the component recognition processing, the control portion 14 first resets a retry frequency n of the memory to n = 0 at a step S11 of Fig. 8. Then, the control portion 14 executes a component recognition processing operation at a step S12. After moving the mounting heads 44a adsorbing the components P to a prescribed recognition height position, the control portion 14 acquires picked-up images of the adsorbed components P by horizontally moving the head unit 44 so that the adsorbed components P pass through the position above the component recognition camera 46 and performing image incorporation on the side of the component recognition camera 46. The control portion 14 performs component recognition of the adsorbed components by performing image recognition processing on the obtained picked-up images.

At a step S13, the control portion 14 determines whether or not the recognition results are excellent. When there are no problems in the recognition results (recognition results OK), the component recognition processing terminates. In a case where the components P are unrecognizable or the like, on the other hand, the control portion 14 determines that there are problems in the component recognition results (NG), and advances to a step 14. At the step S14, the control portion 14 adds the retry frequency n of the memory to n = n + 1.

At a step S15, the control portion 14 determines whether or not the operator is compatible. In other words, the control portion 14 confirms whether or not a flag of the compatibility/incompatibility status is "compatibility" by confirming the compatibility/incompatibility status table 60 (see Fig. 3) of the memory.

In a case where the compatibility/incompatibility status is "compatibility", the control portion 14 sets the determination threshold (three times) in the normal mode to the recognition retry upper limit at a step S16. In a case where the compatibility/incompatibility status is "incompatibility", on the other hand, the control portion 14 sets the determination threshold (30 times) in the continuation preference mode to the recognition retry upper limit at a step S17. Through these steps S15 to S17, the error stop condition (retry upper limit frequency) responsive to the compatibility/incompatibility status is switched between the condition in the normal mode and the condition in the continuation preference mode.

Thereafter the control portion 14 determines whether or not the retry frequency n has reached the retry upper limit frequency at a step S18. In a case where the retry frequency n has not reached the retry upper limit frequency, the processing so returns to the step S12 that a retry of the component recognition processing is executed. In a case where the retry frequency n is determined as reaching the retry upper limit frequency at the step S18, the control portion 14 executes an error response request (controls the control portion 14 to temporarily stop the automatic running).

Running condition switching for the automatic running according to the first embodiment is performed in the aforementioned manner. Also as to the error determination items other than the component recognition, processing of switching (switching between the normal mode and the continuation preference mode) of the error stop condition shown in the steps S15 to S17 is similar, although there are differences between the contents of operations and as to whether it is a retry or a standby.

According to the first embodiment, the following effects can be attained:
According to the first embodiment, as hereinabove described, the control portion 14 acquiring the compatibility/incompatibility status of the operator as to whether or not he/she is compatible with an operator operation request is provided, and the control portion 14 is configured to perform control of switching the running mode for the automatic running to the normal mode and to the continuation preference mode of such a running condition that the operator operation request is harder to generate than in the normal mode in response to the compatibility/incompatibility status. Thus, generation of the operator operation request (error response request) accompanying stoppage of the device can be suppressed when switching the running mode to the continuation preference mode in a case where the compatibility/incompatibility status is incompatibility. Consequently, it becomes possible to continue work processing on the substrates CB by the working portion 11 without stopping the same to the utmost also under such a situation that no operation by the operator can be performed, whereby reduction of working efficiency resulting from stoppage of the device can be suppressed.

According to the first embodiment, as hereinabove described, the substrate working device 1 is so configured that the running is performed under such a running condition that the error response request is harder to generate in the continuation preference mode than in the normal mode (such a running condition that the control portion 14 hardly generates the error response request or less performs the error response request) as to the error stop condition for the automatic running. Thus, the automatic running can be performed under such a running condition that the error response request is hard to generate (running condition hardly causing error stop) in the continuation preference mode, whereby the possibility (frequency) that an error stop occurs can be effectively reduced.

According to the first embodiment, as hereinabove described, the substrate working device 1 is configured to perform an error determination (a determination of performing the error response request) on the basis of such error determination thresholds 63b that the error determination is harder to perform in the continuation preference mode than in the normal mode. Thus, in the continuation preference mode, the determination items can be inhibited from reaching the error determination thresholds 63b to result in performance of an error determination as compared with the normal mode.

According to the first embodiment, as hereinabove described, the error determination thresholds 63b include the upper limit frequency of the retry operation, the standby time up to the error determination of the data transfer (file reading) and the standby time up to the error determination of the substrate transportation. Thus, performance of the retry operation by a larger number of times than in the normal mode or standby for a longer period is allowed in the continuation preference mode. Consequently, the possibility that a temporary error factor is naturally canceled increases, whereby generation of an error response request (stoppage of the device) can be suppressed.

According to the first embodiment, as hereinabove described, the control portion 14 is configured to acquire the future estimated incompatibility and to switch the running mode to the continuation preference mode by determining that the compatibility/incompatibility status is incompatibility in a case where the current time reaches the beginning period (starting time) of the estimated incompatibility. Thus, the control portion 14 can reliably switch the running mode to the continuation preference mode in response to the estimated incompatibility of the operator in a case where the schedule of the operator is previously settled.

### (Second Embodiment)

A component mounting system 200 according to a second embodiment of the present invention is now described with reference to Figs. 1, 2, 9 and 10. In this second embodiment, an example of switching a normal mode and a continuation preference mode in which working speed conditions for automatic running are different from each other is described, dissimilarly to the first embodiment configured to switch the normal mode and the continuation preference mode in which the error stop conditions are different from each other in response to the compatibility/incompatibility status. The component mounting system 200 is an example of the "substrate working system" in the present invention.

As to the component mounting system 200 (see Fig. 1) according to the second embodiment, only a control portion 14a of each substrate working device 1 is different from that in the aforementioned first embodiment while a hardware structure (device construction) is identical, and hence description is omitted.

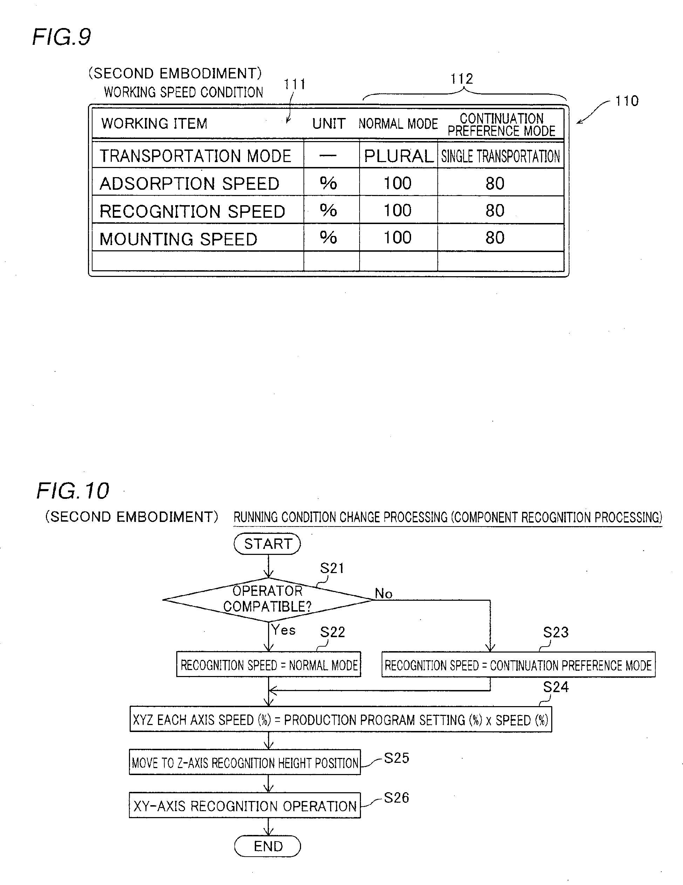

According to the second embodiment, the control portion 14a of the substrate working device 1 stores a working speed condition table 110 for automatic running in a memory, as shown in Fig. 9. According to the second embodiment, theses working speed conditions are different from each other in the normal mode and the continuation preference mode respectively as running conditions for automatic running of the substrate working device 1. In the continuation preference mode, a working speed setting set to a lower speed than in the normal mode is set as the working speed condition.

In the working speed condition, the working speed of a working portion 11 and a working speed setting of a simultaneous transportation number for substrates with a transportation portion 12 are included. An example of a component mounting device 34 (see Fig. 2) is described similarly to the first embodiment.

As shown in Fig. 9, the working speed condition table 110 of the component mounting device 34 includes working items 111 and working speed settings 112. A transportation mode for the substrates with the transportation portion 12 and working speeds in respective operations of adsorption, recognition and mounting with mounting heads 44a are set as the working items 111 of the component mounting device 34, and the working speed settings 112 include respective set values of the transportation mode, the adsorption speed, the recognition speed and the mounting speed.

Speed settings of the adsorption speed, the recognition speed and the mounting speed are previously set in a production program, and expressed in percentage with respect to a speed reference value (reference speed) as to each axis such as an X-, Y- or Z-axis. Working speed settings in the normal mode and the continuation preference mode are set as ratio coefficients (percent) with respect to a production program set value (%) every component.

In the example shown in Fig. 9, the transportation mode is set to a plural transportation mode in the normal mode. In the normal mode, further, speed settings for respective operations are set to 100 % respectively. In the continuation preference mode, on the other hand, the transportation mode is set to a single transportation mode, and speed settings for respective operations are set to 80 % respectively. Thus, in the continuation preference mode, the speed set values are set to lower speeds than in the normal mode.

The plural transportation mode is a mode of also transporting a second substrate to a standby position immediately in front of a mounting operation position in parallel with an operation of transporting a first substrate to the mounting operation position, for example. In a case of performing simultaneous transportation of a plurality of substrates, there arises the possibility that a transportation error occurs due to individual variation (tolerance) between the substrates, slight deviation in timing of moving starting of the plurality of substrates or the like. Such an error can be prevented by a low-speed transportation mode of transporting the substrates one by one in the continuation preference mode.

In a case where an error occurs due to misregistration resulting from inertia in a case of driving the mounting heads 44a (see Fig. 2) at a high speed or the like, error occurrence frequency can be reduced by driving the mounting heads 44a in the continuation preference mode at a lower speed than usual. Consequently, automatic running further suppressing generation of an error response request (operator operation request) as compared with the normal mode is possible in the continuation preference mode having a working speed setting (working speed condition) set to a lower speed than in the normal mode.

Running condition change processing of changing a working speed condition (running condition) by switching between the normal mode and the continuation preference mode with the control portion 14a of the substrate working device 1 according to the second embodiment is now described with reference to Fig. 10. The following description is made with reference to processing of changing the working speed setting for the component recognition processing from among the working items 111 shown in Fig. 9.

When executing the component recognition processing, the control portion 14a first determines whether or not the operator is compatible at a step S21 in Fig. 10.

In a case where a compatibility/incompatibility status is "compatibility", the control portion 14a sets a recognition speed setting (100 %) in the normal mode to the recognition speed at a step S22. In a case where the compatibility/incompatibility status is "incompatibility", on the other hand, the control portion 14a sets a recognition speed setting (80 %) in the continuation preference mode to the recognition speed at a step S23. A working speed condition (recognition speed) responsive to the compatibility/incompatibility status is switched to the normal mode and to the continuation preference mode through these steps S21 to S23.

At a step S24, the control portion 14a reflects the working speed setting on respective axial speeds of X- and Y-axes (a moving mechanism 45 for a head unit 44) and a Z-axis (a Z-axis moving mechanism for the mounting heads 44a). The respective axial speeds (%) of X, Y and Z are set as production program setting (%) × working speed setting (%) per component.

At a step S25, the control portion 14a drives the Z-axis moving mechanism (a Z-axis motor 44b) for the mounting heads 44a, and moves (moves up/down) the mounting heads 44a to a prescribed recognition height position at the X-axis speed set at the step S24. At a step S26, the control portion 14a executes a component recognition operation by horizontally moving the head unit 44 at the X-axis speed and the Y-axis speed set at the step S44. Thus, imaging is performed when adsorbed components pass through a position above a component recognition camera 46, and component recognition based on picked-up images is performed.

Switching of the running condition (working speed condition) for the automatic running according to the second embodiment is performed in the aforementioned manner. Also as to working items other than the component recognition, processing of switching (switching between the normal mode and the continuation preference mode) of a working speed condition shown in the steps S21 to S23 is similar, although there is difference between the contents of operations and operations of the respective axes of X, Y, Z and R.

According to the second embodiment, the following effects can be attained:
According to this second embodiment, generation of the operator operation request (error response request) (performance of the operator operation request) can be suppressed similarly to the aforementioned first embodiment, whereby working efficiency can be inhibited from reduction resulting from stoppage of the device also under such a situation that no operation by the operator can be performed. While it has been possible to suppress generation of an error response request (performance of the error response request) particularly resulting from a transitory factor by relaxation of the determination thresholds in the aforementioned first embodiment, it is possible to suppress generation of an error response request resulting from a high working speed according to the second embodiment.

According to the second embodiment, as hereinabove described, the control portion sets such a running condition that the error response request is harder to generate in the continuation preference mode than in the normal mode as to the working speed condition for the automatic running. Thus, the automatic running can be performed in the continuation preference mode under the running condition that the error response request is hard to generate (such a running condition that the error response request becomes hard to perform) as to the working speed condition, whereby the possibility (frequency) of occurrence of an error stop can be effectively reduced.

According to the second embodiment, as hereinabove described, the substrate working device 1 (the control portion 14a) is so configured that the running is performed in the continuation preference mode with the working speed setting 112 set to a lower speed than in the normal mode as the working speed condition. Thus, the substrate working device can reduce error occurrence frequency by performing automatic running in the continuation preference mode at a lower speed than in the normal mode. According to the second embodiment, as hereinabove described, the working speed settings 112 include the working speed of the working portion 11 and the simultaneous transportation number of the substrates by the transportation portion 12. Thus, occurrence of an error resulting from the working speed of the working portion 11 and an error resulting from the simultaneous transportation number of the substrates CB can be suppressed, whereby generation of the error response request can be effectively reduced.

### (Third Embodiment)

A component mounting system 300 according to a third embodiment of the present invention is now described with reference to Figs. 1 and 9 to 15. In this third embodiment, an example of a structure providing a plurality of continuation preference modes whose running conditions are different from each other and switching the continuation preference modes in response to a remaining time up to an ending period of estimated incompatibility in addition to the structures of the aforementioned first and second embodiments is described. The component mounting system 300 is an example of the "substrate working system" in the present invention.

In the component mounting system 300 (see Fig. 1) according to the third embodiment, only a control portion 14b of each substrate working device 1 is different from that in the first embodiment while a hardware structure (device construction) is identical, and hence description is omitted.

The control portion 14b of the substrate working device 1 according to the third embodiment is configured to determine that a compatibility/incompatibility status is incompatibility and to switch a running mode to any continuation preference mode in a case where the current time reaches a beginning period of estimated incompatibility. Further, the control portion 14b is configured to change a running condition in the continuation preference mode in response to a remaining time up to an ending period of estimated incompatibility (difference between the current time and an ending time) in the continuation preference mode.

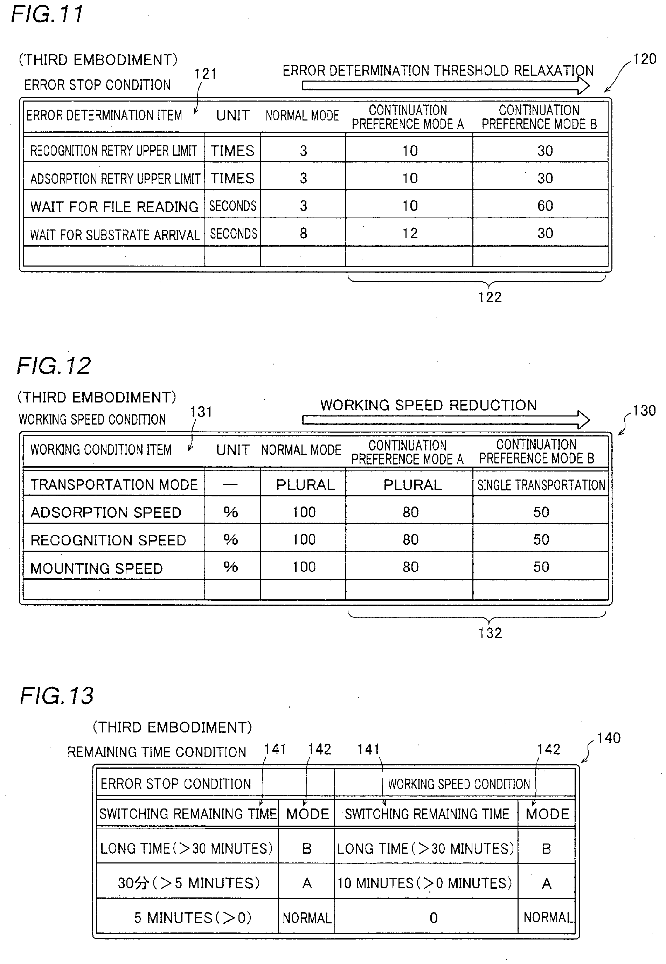

More specifically, a plurality of (two) continuation preference modes A and B whose running conditions are different from each other are set in an error stop condition table 120 and a working speed condition table 130 respectively in the third embodiment, as shown in Figs. 11 and 12. These continuation preference modes A and B are so set that the running conditions stepwisely differ from each other. The control portion 14b is configured to select the continuation preference mode of such a running condition that an operator operation request is harder to generate from the plurality of continuation preference modes A and B as the remaining time up to the ending period of the estimated incompatibility increases in the continuation preference modes.

As shown in Fig. 11, error determination thresholds 122 for respective error determination items 121 are so set that easiness in error determination becomes normal mode > continuation preference mode A > continuation preference mode B in respective running modes of the error stop condition table 120. In other words, larger upper limit frequencies and longer standby times are set for the continuation preference mode B (30 times of recognition retry, 30 times of adsorption retry, 60 seconds for file reading and 30 seconds for substrate arrival) than in the continuation preference mode A (10 times of recognition retry, 10 times of adsorption retry, 10 seconds for file reading and 12 seconds for substrate arrival).

Further, working speed settings 132 for the respective working items 131 are so set that working speeds (i.e., easiness of error occurrence) become normal mode > continuation preference mode A > continuation preference mode B in respective running modes of the working speed condition table 130, as shown in Fig. 12. In other words, a smaller transportation number and speed settings of lower speeds are set for the continuation preference mode B (one and 50 % for respective speeds) than in the continuation preference mode A (plural and 80 % for respective speeds).

The control portion 14b stores a remaining time condition table 140 for switching the running mode in response to the remaining time up to the ending period (ending time) of the estimated incompatibility in a memory, as shown in Fig. 13. The remaining time condition table 140 includes switching remaining time settings 141 performing mode switching and mode settings 142 associated with the switching remaining time settings 141. According to the third embodiment, the switching remaining time settings 141 are individually settable as to the respective ones of the error stop condition table 120 and the working speed condition table 130. The control portion 14b is configured to perform running mode switching responsive to the remaining time by referring to this remaining time condition table 140.

In the example of Fig. 13, the continuation preference mode B whose error determination frequency is the lowest is set to a mode in a case where the remaining time is longer than 30 minutes, as to the error stop condition. The continuation preference mode A is set to a mode in a case where the remaining time is not more than 30 minutes and longer than 5 minutes. Further, the normal mode is set to a mode in a case where the remaining time becomes not more than 5 minutes.

As to the working speed condition, the continuation preference mode B whose error determination frequency is the lowest is set to a mode in a case where the remaining time is longer than 30 minutes. The continuation preference mode A is set to a mode in a case where the remaining time is not more than 10 minutes (longer than 0). Further, the normal mode is set to a mode in a case where the remaining time becomes 0.

Thus, an example of switching the running mode to the normal mode in a case where the remaining time is short as not more than 5 minutes also during an incompatibility time zone in relation to the error stop condition table 120 is shown in the third embodiment.

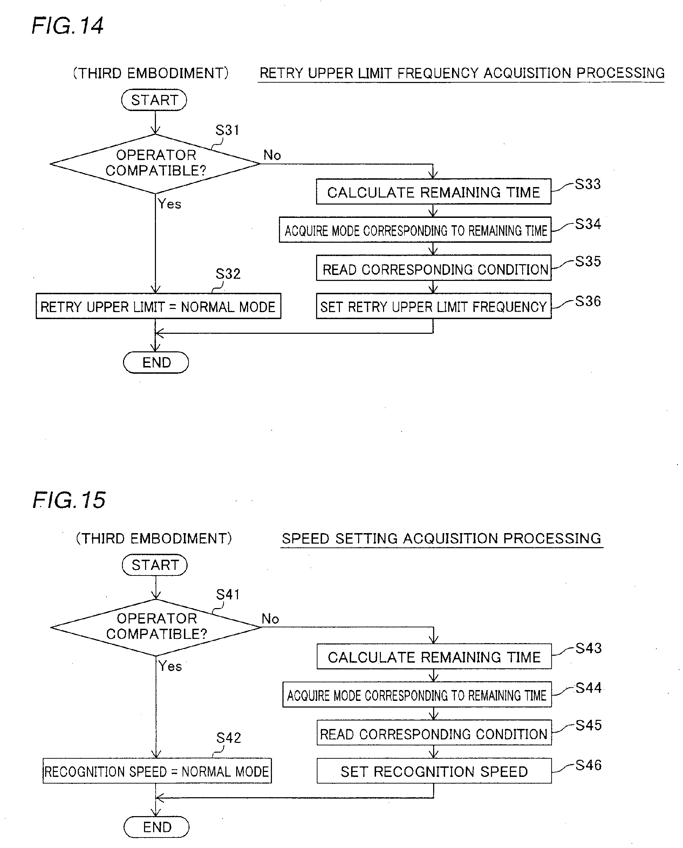

Switching processing between the normal mode and the continuation preference modes A and B by the control portion 14b of the substrate working device 1 according to the third embodiment is now described with reference to Fig. 14. Such an example that a recognition retry upper limit frequency in the error determination items 121 is changed by switching of the running mode related to the error stop condition is described.

A processing flow shown in Fig. 14 is processing executed in place of the steps S15 to S17 in the running condition change processing flow of the first embodiment shown in Fig. 8. Therefore, steps S11 to S14 and S18 before and behind are similar to those in the aforementioned first embodiment.

At a step S31 of Fig. 14, the control portion 14b determines whether or not the operator is compatible. In a case where the compatibility/incompatibility status is "compatibility", the control portion 14b sets a determination threshold (three times) in the normal mode to the recognition retry upper limit at a step S32.

In a case where the compatibility/incompatibility status is "incompatibility", on the other hand, the control portion 14b calculates the remaining time up to the ending period (ending time) of the estimated incompatibility at a step S33. The control portion 14b calculates the remaining time by taking the difference between the ending time and the current time.

At a step S34, the control portion 14b acquires a mode corresponding to the remaining time calculated at the step S53 by referring to the remaining time condition table 140. Thus, the control portion 14b selects any running mode of the continuation preference mode A or B or the normal mode.

At a step S35, the control portion 14b reads a corresponding condition from the error stop condition table 120 of Fig. 11. In a case where the remaining time is larger than 30 minutes and the continuation preference mode B is selected, for example, the control portion 14b reads the determination threshold (30 times) in the continuation preference mode B for the recognition retry upper limit.

At a step S36, the control portion 14b sets the determination threshold (30 times) read at the step S35 as the recognition retry upper limit frequency. Thus, the recognition retry upper limit frequency is changed by switching of the running mode related to the error stop condition.

Consequently, it follows that whether or not a retry frequency n has reached the retry upper limit frequency is determined at the step S18 of Fig. 8 on the basis of the set determination threshold (retry upper limit frequency). Mode selection responsive to the remaining time and setting of an error stop condition responsive to the selected mode are performed through the above.

Such an example that a component recognition speed in the working items 131 is changed by switching of the running mode related to a working speed condition is now described with reference to Fig. 15.

A processing flow shown in Fig. 15 is processing executed in place of the steps S21 to S23 in the working condition change processing flow of the second embodiment shown in Fig. 10. Therefore, subsequent steps S24 to S26 are similar to those in the aforementioned second embodiment.

At a step S41 of Fig. 15, the control portion 14b determines whether or not the operator is compatible. In a case where the compatibility/incompatibility status is "compatibility", the control portion 14b sets a recognition speed setting (100 %) in the normal mode to the component recognition speed at a step S42.

In a case where the compatibility/incompatibility status is "incompatibility", the control portion 14b calculates the remaining time at a step S43, and acquires the mode corresponding to the remaining time from the remaining time condition table 140 at a step S44.

At a step 45, the control portion 14b reads the corresponding condition from the working speed condition table 130 of Fig. 12. In a case where the continuation preference mode B is selected, for example, the control portion 14b reads the recognition speed setting (50 %) in the continuation preference mode B.

At a step S46, the control portion 14b sets the recognition speed setting (50 %) read at the step S45 as the recognition speed. Consequently, the recognition speed is changed by switching of the running mode related to the working speed condition.

After the step S24 of Fig. 10, it follows that the set working speed (recognition speed) is reflected on respective axial speeds of X, Y and Z. Mode selection responsive to the remaining time and setting of working speed condition responsive to the selected mode are performed through the above.

While the example of providing the two types of continuation preference modes A and B has been described in this third embodiment, at least three types of continuation preference modes may be provided for switching the respective continuation preference modes in response to the remaining time. Further, a plurality of continuation preference modes may be provided as to only one of the error stop condition and the working speed condition.

According to the third embodiment, the following effects can be attained, in addition to the effects of the aforementioned first embodiment and the aforementioned second embodiment:
In other words, the control portion changes the running condition in the continuation preference mode in response to the remaining time up to the ending period of the estimated incompatibility in the continuation preference mode according to the third embodiment, as hereinabove described. Even if an error response request is generated at timing when the ending period of the estimated incompatibility approaches, the operator is immediately compatible, and hence influence exerted on working efficiency is remarkably slight. Therefore, it becomes possible to further suppress reduction of the working efficiency by changing the running condition in the continuation preference mode in response to the remaining time up to the ending period of the estimated incompatibility.

According to the third embodiment, as hereinabove described, the control portion 14b is configured to select the continuation preference mode B of the running condition that the operator operation request is harder to generate (such a running condition that the operator operation request is harder to perform) in the continuation preference mode as the remaining time increases. Thus, occurrence of stoppage of the device can be further suppressed in a case where a stop time upon occurrence of the stoppage of the device lengthens (a case where the remaining time is large). In a case where the stop time is small (a case where the remaining time is small), the continuation preference mode A giving more priority to efficiency can be selected. Consequently, it becomes possible to further effectively suppress reduction of the working efficiency while suppressing stoppage of the device under a situation of incompatibility of the operator.

### (Fourth Embodiment)

A component mounting system 400 according to a fourth embodiment of the present invention is now described with reference to Figs. 1 and 16 to 20. In this fourth embodiment, an example of changing a transportation time interval for substrates by a transportation portion 12 is described as a change example of a running condition different from the error stop condition of the aforementioned first embodiment and the working speed condition of the aforementioned second embodiment. While each of the aforementioned first to third embodiments suppresses generation of the error response request among the operator operation requests, this fourth embodiment shows an example of suppressing such a situation that a request for execution of a setup operation among operator operation requests is generated in a time zone of incompatibility. The component mounting system 400 is an example of the "substrate working system" in the present invention.

The change of the working condition by this fourth embodiment particularly relates to a printer 32 and a dispenser 33 among substrate working devices 1. Therefore, it is assumed that description is made with reference to the printer 32, and description as to the structure of the printer 32 is first made. As to the dispenser 33, the same has a structure disclosed in Japanese Patent Laying-Open No. 2008-18298, for example.

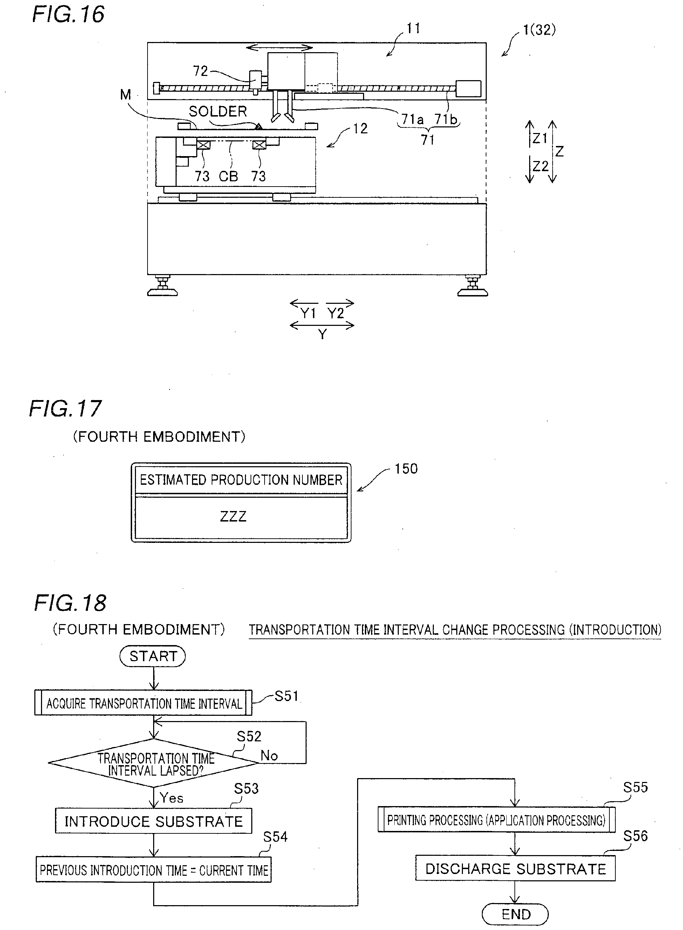

As shown in Fig. 16, a working portion 11 of the printer 32 includes a squeegee unit 71, a solder supply portion 72 and a mask holding portion (not shown) holding a mask M on which a solder printing pattern (opening) for substrates CB is formed. The squeegee unit 71 has a vertically movable squeegee portion 71a and a moving mechanism 71b reciprocating the squeegee portion 71a in a printing direction (Y direction), and is arranged on a position above the mask M.

A transportation portion 12 of the printer 32 is arranged on a position below the mask M. The transportation portion 12 performs introduction/discharge by holding the substrates CB on a pair of conveyors 73, and is capable of moving up/down the substrates CB on a prescribed printing operation position by a vertical moving mechanism (not shown).

The transportation portion 12 moves up the substrates CB transported to the printing operation position, and brings the substrates CB into contact with the lower surface of the mask M. In this state, the printer 32 supplies paste solder from the solder supply portion 72 to the upper surface of the mask M and slides the squeegee portion 71 in the printing direction with respect to the mask M, thereby charging the solder into the opening of the mask M. Consequently, solder printing on the substrates CB on the lower surface side of the mask M is performed.

In such a printer 32, the control portion 14c is configured to change the transportation time interval for the substrates CB by the transportation portion 12 in response to a remaining time up to an ending period of estimated incompatibility in such a continuation preference mode that a compatibility/incompatibility status becomes incompatibility according to the fourth embodiment. More specifically, the control portion 14c is configured to lengthen the transportation time interval as the number of remaining substrates CB up to transition to a setup operation is small with respect to the remaining time. Further, the control portion 14c is configured to control the transportation portion 12 to execute substrate transportation in a case where an elapsed time from a previous transportation time is larger than the transportation time interval.

In order to manage the number of the remaining substrates, the control portion 14c stores an estimated production number table 150 of automatic running in a memory, as shown in Fig. 17. The control portion 14c is configured to count a processed number (printed number) of the substrates CB up to the current time from through the automatic running.

Change processing for the transportation time interval for the substrates in the fourth embodiment is now described with reference to Fig. 18. An example of changing the transportation time interval by adjusting introduction timing for the substrates CB is described.

At a step S51 of Fig. 18, the control portion 14c acquires the transportation time interval.

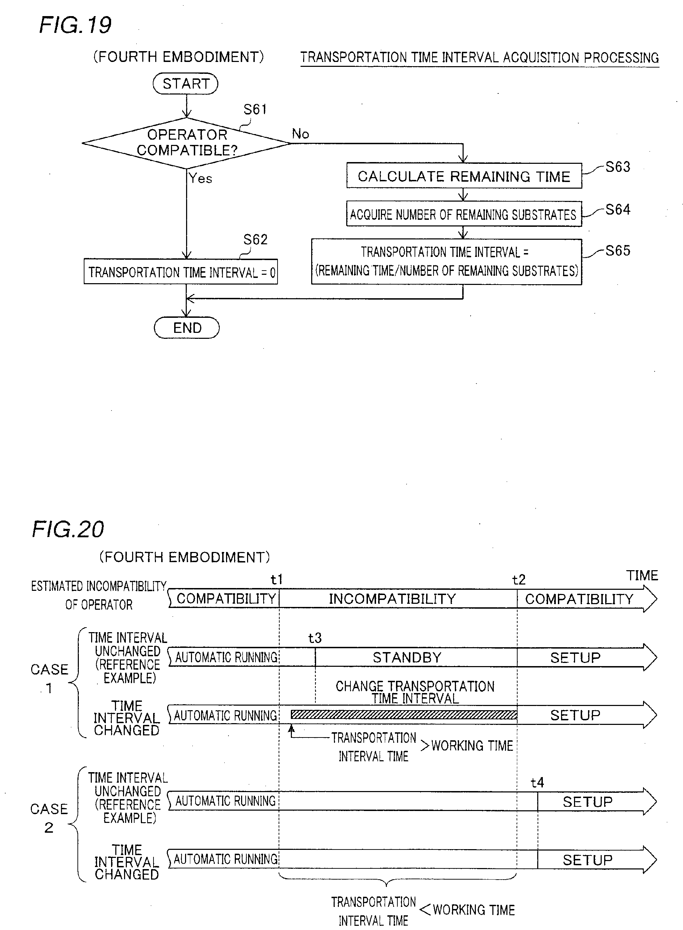

More specifically, the control portion 14c determines whether or not the operator is compatible at a step S61 of Fig. 19 by referring to the compatibility/incompatibility status.

In a case where the compatibility/incompatibility status is "compatibility", the control portion 14c sets the transportation time interval to 0 at a step S62. In other words, the transportation time interval is set to "0 (with no standby time)" in a normal mode.

In a case where the compatibility/incompatibility status is "incompatibility", on the other hand, the control portion 14c calculates a remaining time up to an ending period of estimated incompatibility at a step S63. Further, the control portion 14c calculates the number of remaining substrates at a step S64. In other words, the control portion 14c calculates the number of the remaining substrates by subtracting the number of the substrates CB processed (printed) up to the current time from the estimated production number in the estimated production number table 150.

Then, the control portion 14c calculates the transportation time interval at a step S65. The transportation time interval is calculated as a value (remaining time/remaining number) obtained by dividing the remaining time by the number of the remaining substrates. In the continuation preference mode, the transportation time interval is set to (remaining time/remaining number) through the above.

Then, the control portion 14c determines whether or not a time for the transportation time interval has lapsed from a previous (immediately previous) substrate introduction time (previous introduction time) at a step S52 of Fig. 18, and goes on standby by repeating the determination at the step S52 in a case where the elapsed time is smaller than the transportation time interval. In a case of the normal mode, the transportation time interval equals 0, and hence the control portion 14c advances to a step S53 without a standby time.

In a case where the elapsed time is larger than the transportation time interval, the control portion 14c performs substrate introduction with the transportation portion 12 at a step S53. Then, the control portion 14c updates the previous introduction time to the current time at a step S54.

After the substrate introduction, the control portion 14c performs substrate printing processing at a step S55, and performs discharge of printed substrates with the transportation portion 12 at a step S56. The transportation time interval (introduction interval) change for the substrates is performed in the aforementioned manner.

The control portion 14c may change the transportation time interval (introduction interval) by adjusting discharge timing for the substrates CB. In a case of adjusting the discharge timing, the steps S51 and S52 are carried out immediately before the substrate discharge at the step S56. Further, a reckoning point of time for the elapsed time is not the previous introduction time, but becomes the previous discharge time. Therefore, the step S54 is arranged at the back of the step S56, and "previous discharge time = current time" is set in place of the introduction time.

Functions of the fourth embodiment are now described with reference to Fig. 20.

As hereinabove described, the paste solder is supplied onto the mask M in the printer 32, and hence the paste solder on the mask M is solidified when no operation is performed for a long time. When transition is made to the setup operation (i.e., the operation for the estimated production number terminates) in a case where the compatibility/incompatibility status is "incompatibility" (incompatibility time zone), therefore, there is a possibility that workability of the setup operation deteriorates due to the solidification of the solder or subsequent printing quality degrades. Also in the case of the dispenser 33, a point that there is an apprehension of solidification of a dispensing solution (adhesive or the like) is similar. Therefore, the fourth embodiment reduces a stop time after the transition to the setup operation (after generation of a request for execution of the setup operation) to the minimum through the change of the transportation time interval.

As a specific example, it is assumed that a beginning period (starting time) of estimated incompatibility is a time t1 and an ending period (ending time) is a time t2, as shown in Fig. 20. It is assumed here that change of the running condition is only the transportation time interval and the remaining running conditions are identical in the normal mode and the continuation preference mode.

A case 1 in Fig. 20 is a case where the number of the remaining substrates becomes zero in the middle of the incompatibility time zone in a case of not performing change of the transportation time interval. In the case of not performing change of the transportation time interval (reference example), therefore, a request for execution of the setup operation is generated (the request for execution of the setup operation is performed) and the device stops (waits for the setup operation by the operator) after a time t3 when the number of the remaining substrates becomes zero.

In the case of the fourth embodiment performing change of the transportation time interval, on the other hand, the transportation time interval (= remaining time/remaining number) in the continuation preference mode reaches a larger value as the number of the remaining substrates approaches zero. Consequently, a standby time occurs when the transportation time interval becomes longer than a working time of the printer 32 (time required for performing a printing operation and discharge after substrate introduction and entering a state capable of introducing next substrates). It follows that the transportation time interval uniformly divides the remaining time by the number of the remaining substrates, and hence the number of the remaining substrates becomes zero coincidently to the ending period (time t2) of the estimated incompatibility and the compatibility/incompatibility status becomes operator compatibility while a request for execution of the setup operation is generated in this case 1. Consequently, the stop time for waiting for the setup operation can be minimized.

A case 2 in Fig. 20 is a case where the number of the remaining substrates becomes zero after termination of estimated incompatibility. In a case of running the printer 32 in the normal mode without performing change of the transportation time interval (reference example), therefore, the number of the remaining substrates becomes zero at a time t4 after the ending period (time t2) of the estimated incompatibility. The operator is compatible at the time t4, and hence he/she can perform the setup operation without a standby time when the request for execution of the setup operation is generated, without performing change of the transportation time interval.

In this case 2, the number of the remaining substrates is sufficient during the incompatibility time zone also in the case of the fourth embodiment performing change of the transportation time interval, and hence the transportation time interval (= remaining time/remaining number) in the continuation preference mode reaches a value smaller than the working time of the printer 32. When the printer 32 enters a state where next substrates CB can be introduced in the case 2, therefore, the same enters a state already passing the transportation time interval, and hence no standby time for substrate transportation occurs. Consequently, a result similar to that in a case of running the printer 32 in the normal mode is obtained also during the incompatibility time zone, whereby a tact time is not unnecessarily increased.

According to the fourth embodiment, the following effects can be attained:
According to the fourth embodiment, as hereinabove described, the control portion 14c is configured to change the transportation time interval for the substrates CB by the transportation portion 12 in response to the remaining time up to the ending period of the estimated incompatibility in the continuation preference mode. Thus, the control portion 14c can adjust start timing for the setup operation (operator operation request) in response to the remaining time, whereby the same can attain simplification of the setup operation by preventing solidification and deterioration of the paste solder or
the dispensing solution (adhesive or the like). Consequently, working efficiency including the setup operation can be improved.

According to the fourth embodiment, as hereinabove described, the control portion 14c is configured to lengthen the transportation time interval as the number of the remaining substrates is small with respect to the remaining time in the continuation preference mode and to control the transportation portion 12 to execute substrate transportation in a case where the elapsed time from the previous transportation time is larger than the transportation time interval. Thus, request timing for the setup operation can be matched with timing (ending period of the estimated incompatibility) at which the operator becomes compatible by preventing a case of making transition to the setup operation during the continuation preference mode.

### (Fifth Embodiment)

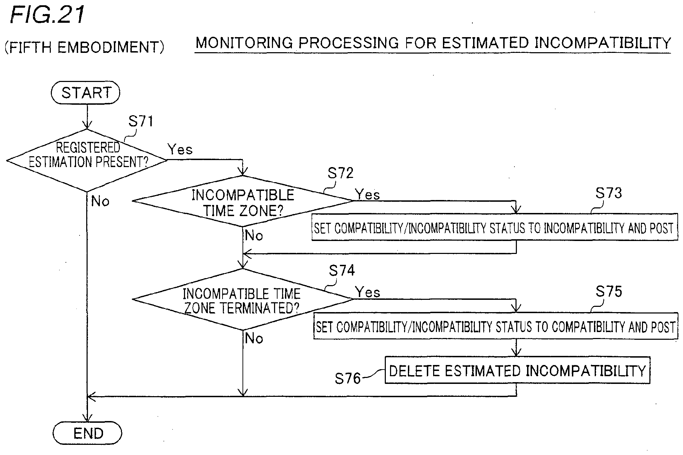

A component mounting system 500 according to a fifth embodiment of the present invention is now described with reference to Figs. 1 and 21. In this fifth embodiment, a case of configuring the component mounting system 500 to post a compatibility/incompatibility status from a server device or one substrate working device into which the compatibility/incompatibility status or estimated incompatibility has been input to another substrate working device is described, dissimilarly to the aforementioned first to fourth embodiments each configured to input (set) the compatibility/incompatibility status and the estimated incompatibility in the control portion of each substrate working device. The component mounting system 500 is an example of the "substrate working system" in the present invention.

The component mounting system 500 according to this fifth embodiment is so configured that a compatibility/incompatibility status or estimated incompatibility is posted to network-connected other substrate working devices 1 when an operator inputs (sets) the compatibility/incompatibility status or the estimated incompatibility in a server device 2 or any substrate working device 1.

In other words, the server device 2 posts the compatibility/incompatibility status to the respective substrate working devices 1 through a network hub 4 when the compatibility/incompatibility status (compatibility or incompatibility) is input in the server device 2, for example, as shown in Fig. 1. Similarly, when the compatibility/incompatibility status is input in a component mounting device 34, for example, a control portion 14d of the component mounting device 34 posts the compatibility/incompatibility status to the other substrate working devices 1 through the network hub 4. Consequently, control portions 14d of the respective substrate working devices 1 perform switching of running modes respectively, in response to the acquired compatibility/incompatibility status. Switching control of the running modes may be any of the aforementioned first to fourth embodiments or a combination of these.

The compatibility/incompatibility status and the estimated incompatibility may be posted to all substrate working devices 1 of the component mounting system 500, or may be posted to only partial substrate working devices 1. In a case where there has been an input of the estimated incompatibility, a beginning period (starting time) and an ending period (ending time) of the estimated incompatibility may be posted, or an incompatibility status in a case where the compatibility/incompatibility status has been updated (changed) on the basis of the estimated incompatibility may be posted. In a case where the server device 2 manages the compatibility/incompatibility status, running conditions in continuation preference modes may be individually posted to the respective substrate working devices 1 along with the compatibility/incompatibility status. In this case, the individual substrate working devices 1 may not store tables of running conditions every mode, but the side of the server device 2 can collectively manage and change the running conditions for the respective substrate working devices 1.

Monitoring processing for estimated incompatibility according to the fifth embodiment is now described with reference to Fig. 21. Such an example that the server device 2 into which estimated incompatibility has been input monitors the estimated incompatibility and posts change of an incompatibility status in a case where the incompatibility status has been changed is described.

At a step S71 of Fig. 21, the server device 2 determines whether or not estimated incompatibility registered in an estimated incompatibility table 62 is present. In a case where no estimated incompatibility is present, the processing terminates. In a case where the estimated incompatibility is present, the server device 2 determines whether or not the current time belongs to an incompatibility time zone at a step S72. In a case where the current time is in the middle of the incompatibility time zone, the server device 2 updates the compatibility/incompatibility status to "incompatibility" and posts the same to each substrate working device 1 at a step S73. In a case where the current time is not in the incompatibility time zone, or in a case where the server device 2 has updated the compatibility/incompatibility status to "incompatibility" at the step S73, the server device 2 determines whether or not the incompatibility time zone has terminated at a step S74.

In a case where the incompatibility time zone has not terminated, the processing terminates as such. In a case where the current time is after the ending time, on the other hand, the server device 2 updates the compatibility/incompatibility status to "incompatibility" and posts the same to each substrate working device 1 at a step S75. Then, the server device 2 deletes the estimated incompatibility passing the ending period (ending time) at a step S76. The server device 2 continuously performs the aforementioned monitoring processing, thereby updating the compatibility/incompatibility status along the registered estimated incompatibility (incompatibility time zone) and performing posting to each substrate working device 1.

A case of posting the compatibility/incompatibility status from any substrate working device 1 to the remaining substrate working devices 1 is also similar, and hence description is omitted.

According to the fifth embodiment, the following effects can be attained:
According to the fifth embodiment, as hereinabove described, the server device 2 is configured to acquire the compatibility/incompatibility status and to post the acquired compatibility/incompatibility status to the substrate working devices 1. Further, the substrate working system 500 is so configured that running modes for automatic running of the substrate working devices 1 are switched to normal modes and to continuation preference modes of such running conditions that operator operation requests are harder to generate than in the normal modes in response to the compatibility/incompatibility status. Thus, generation of operator operation requests can be suppressed when switching the running modes to the continuation preference modes in a case where the compatibility/incompatibility status is incompatibility, whereby it is possible to suppress reduction of working efficiency resulting from stoppage of the devices under such situations that no operations by operators can be performed.

According to the fifth embodiment, as hereinabove described, the control portion 14d of each substrate working device 1 is configured to post the compatibility/incompatibility status to the remaining substrate working devices 1 through a communication portion 13. Thus, it is possible to collectively perform switching to continuation preference modes responsive to compatibility/incompatibility statuses of operators with respect to a plurality of substrate working devices 1 constituting a production line, for example. At this time, an operator can reflect a compatibility/incompatibility status also with respect to the remaining substrate working devices 1 when performing an input or the like of the compatibility/incompatibility status with respect to a prescribed substrate working device 1, whereby input forgetting or the like of the compatibility/incompatibility status can be suppressed.

The embodiments disclosed this time must be considered as illustrative in all points and not restrictive. The range of the present invention is shown not by the above description of the embodiments but by the scope of claims for patent, and all changes (modifications) within the meaning and range equivalent to the scope of claims for patent are further included.

For example, while the example of the component mounting device among the substrate working devices has been described in each of the aforementioned first to third embodiments and the example of the printer has been described in the aforementioned fourth embodiment, the present invention is not restricted to this. It is needless to say that the present invention is also applicable to substrate working devices other than the component mounting device and the printer.

Running conditions for the substrate working device such as the error stop condition described in the aforementioned first embodiment and the working speed condition described in the aforementioned second embodiment vary with the structures of the substrate working devices and the contents of the working operations. Therefore, the running conditions (the error stop condition and the working speed condition) changed in the normal mode and the continuation preference mode are individually set in each substrate working device.

However, conditions related to transfer of data (file reading) and a substrate transportation error among error stop conditions, for example, are common to all substrate working devices so far as the same constitute a circuit board production line. On the other hand, the working contents of the working portions vary with the respective substrate working devices, and hence working speed conditions or the like are individually set for the respective substrate working devices.

The error determination items and the working items described in the aforementioned first and second embodiments and respective determination thresholds and working speed settings are mere examples. Items other than the aforementioned ones may be included in these respective items and set values, or set values other than the aforementioned ones may be set.

While the example of accepting the input of either the compatibility/incompatibility status or the estimated incompatibility has been shown in each of the aforementioned first and second embodiments, the present invention is not restricted to this. For example, the control portion may be made to accept only the compatibility/incompatibility status. In other words, the control portion may bring the compatibility/incompatibility status into incompatibility when the operator becomes absent and switch the same to compatibility in a case where the operator returns.

On the other hand, each of the aforementioned third and fourth embodiments is premised on acceptance of an input of future estimated incompatibility. In the case of the aforementioned third and fourth embodiments, therefore, only the estimated incompatibility may be accepted.

### Description of Reference Signs

1 substrate working device
2 server device
11 working portion
12 transportation portion
13 communication portion
14, 14a, 14b, 14c, 14d control portion
100, 200, 300, 400, 500 component mounting system (substrate working system)
CB substrate
P component (electronic component)

## Claims

1. A substrate working device comprising:
a transportation portion (12) performing introduction/discharge of a substrate (CB) loaded with an electronic component (P);
a working portion (11) performing prescribed work processing on the substrate by automatic running; and
a control portion (14) configured to perform an operator operation request requesting an operator to perform a prescribed operation in response to the status of the automatic running while acquiring a compatibility/incompatibility status of the operator as to whether or not the operator is present and compatible with the operator operation request,
**characterized in that**
the control portion is configured to perform control of
switching a running mode for the automatic running to a normal mode in a case where the operator is present and compatible and
in a case where the operator is not compatible switching the running mode to a continuation preference mode of such a running condition that the operator operation request is harder to generate than in the normal mode, in at least either one of an error stop condition for the automatic running and a working speed condition for automatic running,
in response to the compatibility/incompatibility status, and
the substrate working device is so configured that
whether or not to perform stoppage according to an error response request is determined on the basis of an error determination threshold (63b) at which an error determination is harder to perform in the continuation preference mode than in the normal mode as the error stop condition, and/or
the running is performed in the continuation preference mode at a working speed setting (112) set to a lower speed than in the normal mode as the working speed condition.

2. The substrate working device according to claim 1, wherein
the operator operation request includes the error response request requesting the operator to perform an operation for responding to an error occurring during the automatic running, and
the substrate working device is so configured that the running is performed under such a running condition that the error response request is harder to generate in the continuation preference mode than in the normal mode as to at least either one of the error stop condition for the automatic running and the working speed condition for the automatic running.

3. The substrate working device according to claim 2, wherein
the control portion is configured to perform the error determination for performing the error response request on the basis of the error stop condition.

4. The substrate working device according to claim 3, wherein
the control portion is configured to control the working portion to execute a retry operation for a failing operation in a case where an operation of the working portion included in the work processing fails, and
the error determination threshold includes at least any one of an upper limit frequency up to an error determination on the retry operation by the working portion, a standby time up to an error determination on data transfer and a standby time up to an error determination on substrate transportation.

5. The substrate working device according to claim 2, wherein
the working speed setting includes at least either one of a working speed of the working portion and a simultaneous transportation number for the substrate by the transportation portion.

6. The substrate working device according to claim 1, wherein
the control portion is configured to acquire such future estimated incompatibility that the compatibility/incompatibility status becomes incompatibility and to switch the running mode to the continuation preference mode by determining that the compatibility/incompatibility status is incompatibility in a case where the current time reaches a beginning period (62a) of the estimated incompatibility.

7. The substrate working device according to claim 6, wherein
the control portion is configured to acquire an ending period (62b) of the estimated incompatibility and to change the running condition in the continuation preference mode in response to a remaining time up to the ending period of the estimated incompatibility in the continuation preference mode.

8. The substrate working device according to claim 7, wherein
a plurality of continuation preference modes are so provided that running conditions stepwisely differ from each other, and
the control portion is configured to select the continuation preference mode of such a running condition that the operator operation request is harder to generate from among the plurality of continuation preference modes as the remaining time up to the ending period of the estimated incompatibility increases in the continuation preference mode.

9. The substrate working device according to claim 7, wherein
the operator operation request includes a request for execution of a setup operation for the automatic running, and
the control portion is configured to change a transportation time interval for the substrate by the transportation portion in response to the remaining time up to the ending period of the estimated incompatibility in the continuation preference mode.

10. The substrate working device according to claim 9, wherein
the control portion is configured to lengthen the transportation time interval as the number of remaining substrates up to transition to the setup operation is small with respect to the remaining time and to control the transportation portion to execute substrate transportation in a case where an elapsed time from a previous transportation time is larger than the transportation time interval in the continuation preference mode.

11. The substrate working device according to claim 1, further comprising a communication portion (13) provided on an upstream side or a downstream side of the transportation portion and network-connected with another substrate working device constituting a production line for an electronic circuit board, wherein
the control portion is configured to post the acquired compatibility/incompatibility status to the other substrate working device through the communication portion.

12. A substrate working method comprising steps of:
performing prescribed work processing on a substrate loaded with an electronic component with a substrate working device;
acquiring a compatibility/incompatibility status of an operator as to whether or not the operator is present and compatible with an operator operation request requesting the operator to perform a prescribed operation in response to the status of automatic running; and
**characterized by**
switching
a running mode of the substrate working device to a normal mode in a case where the operator is present and compatible and
in a case where the operator is not compatible the running mode to a continuation preference mode of such a running condition that the operator operation request is harder to generate than in the normal mode, in at least either one of an error stop condition for the automatic running and a working speed condition for automatic running,
in response to the compatibility/incompatibility status, wherein
whether or not to perform stoppage according to an error response request is determined on the basis of an error determination threshold (63b) at which an error determination is harder to perform in the continuation preference mode than in the normal mode as the error stop condition, and/or
the running is performed in the continuation preference mode at a working speed setting (112) set to a lower speed than in the normal mode as the working speed condition.

13. The substrate working method according to claim 12, further comprising a step of performing running under a running condition rendering the operator operation request hard to generate by increase of a unit operation time required from introduction of the substrate up to introduction of a next substrate or by allowing the increase of the unit operation time in the continuation preference mode as compared with a running condition in the normal mode.

14. The substrate working method according to claim 12, wherein
the operator operation request includes the error response request requesting the operator to perform an operation for responding to an error occurring during the automatic running of the substrate working device, and
the method further comprises a step of performing running under such a running condition that the error response request is harder to generate in the continuation preference mode than in the normal mode as to at least either one of the error stop condition for the substrate working device and the working speed condition for the substrate working device.

15. A substrate working system employed in a production line for an electronic circuit board whose substrate is loaded with an electronic component, comprising:
a substrate working device (1) according to any one of claims 1 to 11; and
a server device (2) network-connected with the substrate working device, wherein
the server device is configured to acquire a compatibility/incompatibility status of the operator as to whether or not the operator is compatible with the operator operation request and to post the acquired compatibility/incompatibility status to the substrate working device, and
the substrate working system is so configured that a running mode for the automatic running of the substrate working device is switched to a normal mode and to a continuation preference mode of such a running condition that the operator operation request is harder to generate than in the normal mode in response to the compatibility/incompatibility status.

## Patentansprüche

1. Substratbearbeitungsvorrichtung, die umfasst:
einen Transportabschnitt (12), der das Einführen/Abgeben eines Substrats (CB), das mit einer elektronischen Komponente (P) bestückt ist, durchführt;
einen Bearbeitungsabschnitt (11), der durch automatisches Ausführen eine vorgeschriebene Bearbeitung auf dem Substrat durchführt;
einen Steuerabschnitt (14), der konfiguriert ist, um eine Bediener-Arbeitsschrittanforderung durchzuführen, die einen Bediener auffordert, ansprechend auf den Status der automatischen Ausführung einen vorgeschriebenen Arbeitsschritt durchzuführen, während ein Kompatibilitäts-/Inkompatibilitätsstatus des Bedieners bezüglich dessen erfasst wird, ob der Bediener anwesend und mit der Bediener-Arbeitsschrittanforderung kompatibel ist oder nicht,
**dadurch gekennzeichnet, dass**
der Steuerabschnitt konfiguriert ist, um in einem Fall, in dem der Bediener anwesend und kompatibel ist, eine Steuerung zum Umschalten einer Ausführungsbetriebsart für die automatische Ausführung auf eine Normalbetriebsart durchzuführen, und
in einem Fall, in dem der Bediener nicht kompatibel ist, die Ausführungsbetriebsart unter einer Fehlerstoppbedingung und/oder einer Arbeitsgeschwindigkeitsbedingung für die automatische Ausführung ansprechend auf den Kompatibilitäts-/Inkompatibilitätsstatus auf eine Fortsetzungsvorzugsbetriebsart einer derartigen Ausführungsbedingung umzuschalten, dass die Bediener-Arbeitsschrittanforderung schwerer als in der Normalbetriebsart zu erzeugen ist,
und die Substratbearbeitungsvorrichtung derart konfiguriert ist, dass ob gemäß einer Fehlerantwortanforderung ein Stopp durchgeführt werden soll oder nicht, auf der Basis einer Fehlerbestimmungsschwelle (63b), bei der eine Fehlerbestimmung in der Fortsetzungsvorzugsbetriebsart schwerer als in der Normalbetriebsart durchzuführen ist, als die Fehlerstoppbedingung bestimmt wird, und/oder
die Ausführung in der Fortsetzungsvorzugsbetriebsart mit einer Arbeitsgeschwindigkeitseinstellung (112), die auf eine niedrigere Geschwindigkeit als in der Normalbetriebsart festgelegt wird, als die Arbeitsgeschwindigkeitsbedingung durchgeführt wird.

2. Substratbearbeitungsvorrichtung nach Anspruch 1, wobei
die Bediener-Arbeitsschrittanforderung die Fehlerantwortanforderung umfasst, die den Bediener auffordert, einen Arbeitsschritt durchzuführen, um auf einen Fehler zu reagieren, der während der automatischen Ausführung auftritt, und
die Substratbearbeitungsvorrichtung derart konfiguriert ist, dass die Ausführung unter einer derartigen Ausführungsbedingung durchgeführt wird, dass die Fehlerantwortanforderung in Bezug auf die Fehlerstoppbedingung für die automatische Ausführung und/oder die Arbeitsgeschwindigkeitsbedingung für die automatische Ausführung in der Fortsetzungsvorzugsbetriebsart schwerer als in der Normalbetriebsart zu erzeugen ist.

3. Substratbearbeitungsvorrichtung nach Anspruch 2, wobei
der Steuerabschnitt konfiguriert ist, um die Fehlerbestimmung für das Durchführen der Fehlerantwortanforderung auf der Basis der Fehlerstoppbedingung durchzuführen.

4. Substratbearbeitungsvorrichtung nach Anspruch 3, wobei
der Steuerabschnitt konfiguriert ist, um den Bearbeitungsabschnitt zu steuern, um in einem Fall, in dem ein Arbeitsschritt des in der Arbeitsverarbeitung enthaltenen Bearbeitungsabschnitts fehlschlägt, einen Wiederholungsarbeitsschritt für einen fehlgeschlagenen Arbeitsschritt auszuführen, und
die Fehlerbestimmungsschwelle eine obere Grenzhäufigkeit bis zu einer Fehlerbestimmung für den Wiederholungsarbeitsschritt durch den Bearbeitungsabschnitt, eine Wartezeit für eine Fehlerbestimmung für die Datenübertragung und eine Wartezeit bis zu einer Fehlerbestimmung für den Substrattransport umfasst.

5. Substratbearbeitungsvorrichtung nach Anspruch 2, wobei
die Arbeitsgeschwindigkeitsfestlegung eine Arbeitsgeschwindigkeit des Bearbeitungsabschnitts und/oder eine gleichzeitige Transportanzahl für das Substrat durch den Transportabschnitt umfasst.

6. Substratbearbeitungsvorrichtung nach Anspruch 1, wobei
der Steuerabschnitt konfiguriert ist, um eine derartige zukünftige geschätzte Inkompatibilität, bei welcher der Kompatibilitäts-/Inkompatibilitätsstatus Inkompatibilität wird, zu erfassen und die Ausführungsbetriebsart auf die Fortsetzungsvorzugsbetriebsart umzuschalten, indem in einem Fall, in dem die aktuelle Zeit eine Anfangszeitspanne (62a) der geschätzten Inkompatibilität erreicht, bestimmt wird, dass der Kompatibilitäts-/Inkompatibilitätsstatus Inkompatibilität ist.

7. Substratbearbeitungsvorrichtung nach Anspruch 6, wobei
der Steuerabschnitt konfiguriert ist, um eine Endzeitspanne (62b) der geschätzten Inkompatibilität zu erfassen und die Ausführungsbedingung in der Fortsetzungsvorzugsbetriebsart ansprechend auf eine verbleibende Zeit bis zu der Endzeitspanne der geschätzten Inkompatibilität in der Fortsetzungsvorzugsbetriebsart zu ändern.

8. Substratbearbeitungsvorrichtung nach Anspruch 7, wobei
mehrere Fortsetzungsvorzugsbetriebsarten derart bereitgestellt werden, dass sich Ausführungsbedingungen schrittweise voneinander unterscheiden, und
der Steuerabschnitt konfiguriert ist, um die Fortsetzungsvorzugsbetriebsart einer derartigen Ausführungsbedingung aus den mehreren Fortsetzungsvorzugsbetriebsarten auszuwählen, dass die Bediener-Arbeitsschrittanforderung schwerer zu erzeugen ist, wenn die verbleibende Zeit bis zu der Endzeitspanne der geschätzten Inkompatibilität in der Fortsetzungsvorzugsbetriebsart zunimmt.

9. Substratbearbeitungsvorrichtung nach Anspruch 7, wobei
die Bediener-Arbeitsschrittanforderung eine Anforderung für die Ausführung eines Einrichtungsarbeitsschritts für die automatische Ausführung umfasst, und
der Steuerabschnitt konfiguriert ist, um ein Transportzeitintervall für das Substrat durch den Transportabschnitt ansprechend auf die verbleibende Zeit bis zu der Endzeitspanne der geschätzten Inkompatibilität in der Fortsetzungsvorzugsbetriebsart zu ändern.

10. Substratbearbeitungsvorrichtung nach Anspruch 9, wobei
der Steuerabschnitt konfiguriert ist, um das Transportzeitintervall zu verlängern, wenn die Anzahl verbleibender Substrate, die an den Einrichtungsarbeitsschritt überführt werden soll, in Bezug auf die verbleibende Zeit klein ist, und den Transportabschnitt zu steuern, um den Substrattransport in einem Fall, in dem eine vergangene Zeit seit einer vorhergehenden Zeit größer als das Transportzeitintervall in der Fortsetzungsvorzugsbetriebsart ist, auszuführen.

11. Substratbearbeitungsvorrichtung nach Anspruch 1, die ferner einen Kommunikationsabschnitt (13) umfasst, der auf einer laufaufwärtigen Seite oder einer laufabwärtigen Seite des Transportabschnitts bereitgestellt ist und über ein Netzwerk mit einer anderen Substratbearbeitungsvorrichtung verbunden ist, wobei eine Fertigungslinie für eine elektronische Leiterplatte gebildet wird, wobei
der Steuerabschnitt konfiguriert ist, um den erfassten Kompatibilitäts-/Inkompatibilitätsstatus der anderen Substratbearbeitungsvorrichtung durch den Kommunikationsabschnitt bekannt zu machen.

12. Substratbearbeitungsverfahren, das die folgenden Schritte umfasst:
Durchführen einer vorgeschriebenen Bearbeitung an einem Substrat, das, das mit einer elektronischen Komponente bestückt ist;
Erfassen eines Kompatibilitäts-/Inkompatibilitätsstatus eines Bedieners bezüglich dessen, ob der Bediener anwesend und mit einer Bediener-Arbeitsschrittanforderung, die den Bediener auffordert, ansprechend auf den Status der automatischen Ausführung einen vorgeschriebenen Arbeitsschritt durchzuführen, kompatibel ist oder nicht,
**gekennzeichnet durch**
Umschalten
einer Ausführungsbetriebsart der Substratbearbeitungsvorrichtung auf eine Normalbetriebsart in einem Fall, in dem der Bediener anwesend und kompatibel ist, und
in einem Fall, in dem der Bediener nicht kompatibel ist, unter einer Fehlerstoppbedingung für die automatische Ausführung und/oder einer Arbeitsgeschwindigkeitsbedingung für die automatische Ausführung ansprechend auf den Kompatibilitäts-/Inkompatibilitätsstatus auf eine Fortsetzungsvorzugsbetriebsart einer derartigen Ausführungsbedingung, dass die Bediener-Arbeitsschrittanforderung schwerer als in der Normalbetriebsart zu erzeugen ist, wobei
ob gemäß einer Fehlerantwortanforderung ein Stopp durchgeführt werden soll oder nicht, auf der Basis einer Fehlerbestimmungsschwelle (63b) bestimmt wird, bei der eine Fehlerbestimmung in der Fortsetzungsvorzugsbetriebsart schwerer als in der Normalbetriebsart durchzuführen ist, und/oder
die Ausführung in der Fortsetzungsvorzugsbetriebsart mit einer Arbeitsgeschwindigkeitseinstellung (112), die auf eine niedrigere Geschwindigkeit als in der Normalbetriebsart festgelegt wird, als die Arbeitsgeschwindigkeitsbedingung durchgeführt wird.

13. Substratbearbeitungsverfahren nach Anspruch 12, das ferner einen Schritt zur Durchführung der Ausführung unter einer Ausführungsbedingung umfasst, welche die Bediener-Arbeitsschrittanforderung schwer zu erzeugen macht, indem eine Einheitsbetriebszeit, die von der Einführung des Substrats bis zur Einführung eines nächsten Substrats erforderlich ist, verlängert wird, oder indem die Zunahme der Einheitsbetriebszeit in der Fortsetzungsvorzugsbetriebsart im Vergleich zu einer Ausführungsbedingung in der Normalbetriebsart zugelassen wird.

14. Substratbearbeitungsverfahren nach Anspruch 12, wobei
die Bediener-Arbeitsschrittanforderung die Fehlerantwortanforderung umfasst, die den Bediener auffordert, einen Arbeitsschritt zum Reagieren auf einen Fehler der während der automatischen Ausführung der Substratbearbeitungsvorrichtung auftritt, durchzuführen, und
das Verfahren ferner einen Schritt zur Durchführung der Ausführung bezüglich der Fehlerstoppbedingung für die Substratbearbeitungsvorrichtung und/oder der Arbeitsgeschwindigkeitsbedingung für die Substratbearbeitungsvorrichtung unter einer derartigen Ausführungsbedingung umfasst, dass die Fehlerantwortaufforderung in der Fortsetzungsvorzugsbetriebsart schwerer als in der Normalbetriebsart zu erzeugen ist.

15. Substratbearbeitungssystem, das in einer Produktionslinie für eine elektronische Leiterplatte, deren Substrat mit einer elektronischen Komponente bestückt ist, verwendet wird, das umfasst:
eine Substratbearbeitungsvorrichtung (1) nach einem der Ansprüche 1 bis 11; und
eine Servervorrichtung (2), die über ein Netzwerk mit der Substratbearbeitungsvorrichtung verbunden ist, wobei
die Servervorrichtung konfiguriert ist, um einen Kompatibilitäts-/Inkompatibilitätsstatus des Bedieners bezüglich dessen zu erfassen, ob der Bediener mit der Bediener-Arbeitsschrittanforderung kompatibel ist oder nicht, und den erfassten Kompatibilitäts-/Inkompatibilitätsstatus der Substratbearbeitungsvorrichtung bekannt zu machen, und
die Substratbearbeitungsvorrichtung derart konfiguriert ist, dass eine Ausführungsbetriebsart für die automatische Ausführung der Substratbearbeitungsvorrichtung ansprechend auf den Kompatibilitäts-/Inkompatibilitätsstatus auf eine Normalbetriebsart und auf eine Fortsetzungsvorzugsbetriebsart mit einer derartigen Ausführungsbedingung geschaltet wird, dass die Bediener-Arbeitsschrittanforderung schwerer als in der Normalbetriebsart zu erzeugen ist.

## Revendications

1. Dispositif de traitement de substrat comportant :
une portion de transport (12) réalisant une introduction/évacuation d'un substrat (CB) équipé d'un composant électronique (P) ;
une portion de traitement (11) réalisant un travail de traitement prescrit sur le substrat par exécution automatique ; et
une portion de commande (14) configurée pour réaliser une requête d'opération à l'opérateur demandant à un opérateur de réaliser une opération prescrite en réponse au statut de l'exécution automatique, tout en acquérant un statut de compatibilité/incompatibilité de l'opérateur quant à savoir si oui ou non l'opérateur est présent et compatible avec la requête d'opération à l'opérateur,
**caractérisé en ce que**
la portion de commande est configurée pour réaliser une commande de
commutation d'un mode d'exécution pour l'exécution automatique vers un mode normal dans un cas où l'opérateur est présent et compatible et
dans un cas où l'opérateur n'est pas compatible, commutation du mode d'exécution vers un mode de préférence de continuation d'une condition d'exécution telle que la requête d'opération à l'opérateur est plus difficile à produire que dans le mode normal, dans au moins un élément quelconque parmi une condition d'arrêt d'erreur pour l'exécution automatique et une condition de vitesse de traitement pour l'exécution automatique,
en réponse au statut de compatibilité/incompatibilité et
le dispositif de traitement de substrat est configuré de sorte que
le fait de savoir s'il convient ou non de réaliser une interruption en fonction d'une requête de réponse à l'erreur est déterminé sur la base d'un seuil de détermination d'erreur (63b) à partir duquel une détermination d'erreur est plus difficile à réaliser dans le mode de préférence de continuation que dans le mode normal, en tant que condition d'arrêt d'erreur, et/ou
l'exécution est réalisée dans le mode de préférence de continuation à un réglage de vitesse de traitement (112) défini sur une vitesse inférieure à celle du mode normal, en tant que condition de vitesse de traitement.

2. Dispositif de traitement de substrat selon la revendication 1, dans lequel
la requête d'opération à l'opérateur inclut la requête de réponse à l'erreur demandant à l'opérateur de réaliser une opération afin de répondre à une erreur se produisant pendant l'exécution automatique et
le dispositif de traitement de substrat est configuré de sorte que l'exécution soit réalisée dans une condition d'exécution telle que la requête de réponse à l'erreur est plus difficile à produire dans le mode de préférence de continuation que dans le mode normal, en tant qu'au moins un élément quelconque parmi la condition d'arrêt d'erreur pour l'exécution automatique et la condition de vitesse de traitement pour l'exécution automatique.

3. Dispositif de traitement de substrat selon la revendication 2, dans lequel
la portion de commande est configurée de manière à réaliser la détermination d'erreur afin de réaliser la requête de réponse à l'erreur sur la base de la condition d'arrêt d'erreur.

4. Dispositif de traitement de substrat selon la revendication 3, dans lequel
la portion de commande est configurée pour commander la portion de traitement afin d'exécuter une opération de nouvel essai pour une opération défaillante dans un cas où une opération de la portion de traitement incluse dans le travail de traitement échoue et
le seuil de détermination d'erreur inclut au moins un élément quelconque parmi une fréquence de limite supérieure jusqu'à une détermination d'erreur sur l'opération de nouvel essai par la portion de traitement, un temps de veille jusqu'à une détermination d'erreur sur un transfert de données et un temps de veille jusqu'à une détermination d'erreur sur un transport de substrat.

5. Dispositif de traitement de substrat selon la revendication 2, dans lequel
le réglage de la vitesse de traitement inclut au moins un élément quelconque parmi une vitesse de traitement de la portion de traitement et un nombre de transports simultanés pour le substrat par la portion de transport.

6. Dispositif de traitement de substrat selon la revendication 1, dans lequel
la portion de commande est configurée pour acquérir une future incompatibilité estimée telle que le statut de compatibilité/incompatibilité passe à incompatibilité et pour commuter le mode d'exécution sur le mode de préférence de continuation par détermination que le statut de compatibilité/incompatibilité est incompatibilité dans un cas où le temps actuel atteint une période de mise en route (62a) de l'incompatibilité estimée.

7. Dispositif de traitement de substrat selon la revendication 6, dans lequel
la portion de commande est configurée pour acquérir une période de cessation (62b) de l'incompatibilité estimée et pour modifier la condition d'exécution dans le mode de préférence de continuation en réponse à un temps restant jusqu'à la période de cessation de l'incompatibilité estimée dans le mode de préférence de continuation.

8. Dispositif de traitement de substrat selon la revendication 7, dans lequel
une pluralité de modes de préférence de continuation sont fournis de sorte que les conditions d'exécution diffèrent graduellement les unes des autres et
la portion de commande est configurée pour sélectionner le mode de préférence de continuation d'une condition d'exécution telle que la requête d'opération à l'opérateur est plus difficile à produire parmi la pluralité de modes de préférence de continuation puisque le temps restant jusqu'à la période de cessation de l'incompatibilité estimée augmente dans le mode de préférence de continuation.

9. Dispositif de traitement de substrat selon la revendication 7, dans lequel
la requête d'opération à l'opérateur inclut une requête d'exécution d'une opération de configuration pour l'exécution automatique et
la portion de commande est configurée pour modifier un intervalle de temps de transport pour le substrat par la portion de transport en réponse au temps restant jusqu'à la période de cessation de l'incompatibilité estimée dans le mode de préférence de continuation.

10. Dispositif de traitement de substrat selon la revendication 9, dans lequel
la portion de commande est configurée pour rallonger l'intervalle de temps de transport tandis que le nombre de substrats restants jusqu'à la transition vers l'opération de configuration est réduit par rapport au temps restant et pour commander la portion de transport afin qu'elle exécute un transport de substrat dans un cas où un temps écoulé par rapport à un temps de transport précédent est supérieur à l'intervalle de temps de transport dans le mode de préférence de continuation.

11. Dispositif de traitement de substrat selon la revendication 1, comportant en outre une portion de communication (13) prévue sur un côté amont ou un côté aval de la portion de transport et connectée en réseau à un autre dispositif de traitement de substrat constituant une ligne de production pour une carte de circuit électronique, dans lequel
la portion de commande est configurée pour publier le statut acquis de compatibilité/incompatibilité sur l'autre dispositif de traitement de substrat via la portion de communication.

12. Procédé de traitement de substrat comportant les étapes de :
réalisation d'un travail de traitement prescrit sur un substrat équipé d'un composant électronique avec un dispositif de traitement de substrat ;
acquisition d'un statut de compatibilité/incompatibilité d'un opérateur quant à savoir si oui ou non l'opérateur est présent et compatible avec une requête d'opération à l'opérateur demandant à l'opérateur de réaliser une opération prescrite en réponse au statut d'exécution automatique ; et
**caractérisé par**
la commutation
d'un mode d'exécution du dispositif de traitement de substrat vers un mode normal dans un cas où l'opérateur est présent et compatible et
dans un cas où l'opérateur n'est pas compatible, du mode d'exécution vers un mode de préférence de continuation d'une condition d'exécution telle que la requête d'opération à l'opérateur est plus difficile à produire que dans le mode normal, dans au moins un élément quelconque parmi une condition d'arrêt d'erreur pour l'exécution automatique et une condition de vitesse de traitement pour l'exécution automatique,
en réponse au statut de compatibilité/incompatibilité, dans lequel
savoir s'il convient ou non de réaliser une interruption en fonction d'une requête de réponse à l'erreur est déterminé sur la base d'un seuil de détermination d'erreur (63b) à partir duquel une détermination d'erreur est plus difficile à réaliser dans le mode de préférence de continuation que dans le mode normal, en tant que condition d'arrêt d'erreur et/ou
l'exécution est réalisée dans le mode de préférence de continuation selon un réglage de vitesse de traitement (112) défini sur une vitesse inférieure à celle du mode normal, en tant que condition de vitesse de traitement.

13. Procédé de traitement de substrat selon la revendication 12, comportant en outre une étape de réalisation d'une exécution sous une condition d'exécution rendant la requête d'opération à l'opérateur difficile à produire par augmentation d'un temps d'opération d'unité requis, entre l'introduction du substrat et l'introduction d'un substrat suivant, ou par autorisation de l'augmentation du temps d'opération de l'unité dans le mode de préférence de continuation par rapport à une condition d'exécution dans le mode normal.

14. Procédé de traitement de substrat selon la revendication 12, dans lequel
la requête d'opération à l'opérateur inclut la requête de réponse à l'erreur demandant à l'opérateur de réaliser une opération pour répondre à une erreur se produisant pendant l'exécution automatique du dispositif de traitement de substrat et
le procédé comporte en outre une étape de réalisation d'une exécution dans une condition d'exécution telle que la requête de réponse à l'erreur est plus difficile à produire dans le mode de préférence de continuation que dans le mode normal, en tant que au moins un élément quelconque parmi la condition d'arrêt d'erreur pour le dispositif de traitement de substrat et la condition de vitesse de traitement pour le dispositif de traitement de substrat.

15. Système de traitement de substrat employé dans une ligne de production pour une carte de circuit électronique dont le substrat est équipé d'un composant électronique, comportant :
un dispositif de traitement de substrat (1) selon l'une quelconque des revendications 1 à 11 ; et
un dispositif de serveur (2) connecté en réseau au dispositif de traitement de substrat, dans lequel
le dispositif de serveur est configuré pour acquérir un statut de compatibilité/incompatibilité de l'opérateur quant à savoir si oui ou non l'opérateur est compatible avec la requête d'opération à l'opérateur et pour publier le statut acquis de compatibilité/incompatibilité sur le dispositif de traitement de substrat et
le système de traitement de substrat est configuré de sorte qu'un mode d'exécution pour l'exécution automatique du dispositif de traitement de substrat soit commuté sur un mode normal et sur un mode de préférence de continuation d'une condition d'exécution telle que la requête d'opération à l'opérateur est plus difficile à produire que dans le mode normal en réponse au statut de compatibilité/incompatibilité.
